(19)

**Europäisches Patentamt**

**European Patent Office**

**Office européen des brevets**

(11) **EP 4 492 274 A1**

(12) **EUROPEAN PATENT APPLICATION**

(43) Date of publication:
**15.01.2025 Bulletin 2025/03**

(21) Application number: **23306189.4**

(22) Date of filing: **11.07.2023**

(51) International Patent Classification (IPC):
**G06F 30/12** (2020.01)  **G06T 17/10** (2006.01)
**G06V 20/64** (2022.01)

(52) Cooperative Patent Classification (CPC):
**G06F 30/12; G06T 17/10;** G06T 19/20;
G06V 20/653

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Dassault Systèmes**
**78140 Vélizy-Villacoublay (FR)**

(72) Inventors:
• **BRIFAULT, Lucas**
**78140 Vélizy-Villacoublay (FR)**
• **BRUS, Mathieu**
**78140 Vélizy-Villacoublay (FR)**

(74) Representative: **Bandpay & Greuter**
**11 rue Christophe Colomb**
**75008 Paris (FR)**

(54) **DRAFT FEATURE DETECTION METHOD**

(57) The disclosure notably relates to a computer-implemented method for CAD volume draft operator detection in a discrete 3D model representing a mechanical part. The method comprises obtaining a segmentation of the discrete 3D model, iteratively grouping segments of the segmentation, and determining one or more CAD volume draft operators, each CAD volume draft operator corresponding to a respective group. Two segments of a pair of segments are grouped if: each segment of the pair is a drafted surface and both segments have a same respective drafting axis, and both segments have a same respective draft angle relative to the respective drafting axis, or at least one segment has a zero angle relative to the respective drafting axis; or one segment of the pair is a drafted surface and the other segment is a closing plane.

EP 4 492 274 A1

**Description**

**TECHNICAL FIELD**

The disclosure relates to the field of computer programs and systems, and more specifically to a method, system, and program for CAD volume draft operator detection in a discrete 3D model representing a mechanical part.

**BACKGROUND**

A number of systems and programs are offered on the market for the design, the engineering, and the manufacturing of objects. CAD is an acronym for Computer-Aided Design, e.g. it relates to software solutions for designing an object. CAE is an acronym for Computer-Aided Engineering, e.g., it relates to software solutions for simulating the physical behavior of a future product. CAM is an acronym for Computer-Aided Manufacturing, e.g., it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production, and service.

In this contexts and other contexts, processing CAD 3D models is gaining wide importance. Specifically, detecting a draft operator in a 3D model representing a mechanical part is of particular importance due to the widespread application of draft operators in designing said part in view of its manufacturing.

There is however a need for improved solutions for CAD 3D model processing, and CAD volume draft operator detection.

**SUMMARY**

It is therefore provided a computer-implemented method for CAD volume draft operator detection in a discrete 3D model representing a mechanical part. The method comprises obtaining a segmentation of the discrete 3D model, the discrete 3D model including a skin representing an outer surface of the mechanical part, the segmentation comprising segments each representing a skin portion. The method further comprises iteratively grouping segments, where two segments of a pair of segments are grouped if: each segment of the pair is a drafted surface and both segments have a same respective drafting axis, and both segments have a same respective draft angle relative to the respective drafting axis, or at least one segment has a zero angle relative to the respective drafting axis; or one segment of the pair is a drafted surface and the other segment is a closing plane; at least one iteration grouping a pair of segments with at least one segment having a non-zero draft angle relative to the respective drafting axis. The method further comprises determining one or more CAD volume draft operators, each CAD volume draft operator corresponding to a respective group.

The method may comprise one or more of the following:

- the method comprises determining all segments that are drafted surfaces, including performing a test of whether $\exists u \in \mathbb{R}^3 \setminus \{(0,0,0)\}, \theta \in \mathbb{R}^3 : \forall p \in S$, $n_p \cdot u = \boldsymbol{sin(\theta)}$, where $S$ is a segment and $n_p$ is the normal vector to the segment $S$ at point $p$, the surfaces satisfying the test being determined as drafted surfaces;

- the performing of the test comprises evaluating, for each segment $S$ $\exists u \in \mathbb{R}^3 : |u| = 1$ and $\mathcal{J}_S(u) \le \epsilon$ where $\mathcal{J}_S : \mathbb{R}^3 \rightarrow \mathbb{R}_+$ and is defined by $\mathcal{J}_S(u) = \frac{1}{\mathcal{A}_S} \int_S \big(u \cdot (n_p - \bar{n})\big)^2 dvol_S$, $\mathcal{A}_S = \int_S dvol_S$ and $vol_S$ is the canonical measure on $S$, $\epsilon > 0$, $\bar{n}$ is the mean normal of $S$ defined as

$$\bar{n} = \frac{1}{|S|} \int_S n \, dvol_S;$$

- the evaluation comprises solving an optimization problem of the type

$$\min_{u \in \mathbb{R}^3} \quad u^T \widetilde{\mathbf{T}}_S u$$
$$s.t. \quad |u| = 1$$

where $\tilde{T}_S$ is of the type

$$\widetilde{\mathbf{T}}_S = \frac{1}{\mathcal{A}_S} \int_S (n - \bar{n})(n - \bar{n})^T dvol_S \, ;$$

- the solving of the optimization problem comprises finding the smallest eigenvalue of $\tilde{T}_S$ as well as its associated eigenvector $u_S^m$, wherein the testing comprises testing $\lambda_S^m \leq \epsilon$ wherein $\lambda_S^m$ the smallest eigenvalue;
- iteratively grouping segments comprises one or more iterations of:

  ◦ exploring a pair of segments;
  ◦ determining whether:

    ▪ a first disparity between the value of a draft-detection objective function for a union of the segments of the explored pair and a weighted sum of the values of the draft-detection objective function for the segments of the explored pair is lower than a first predefined threshold, the sum being weighted based on the areas of the segments, or
    ▪ a second disparity between the value of a draft-closing objective function for the segments of the explored pair and the weighted sum is lower than a second predefined threshold, the draft-closing objective function rewarding orthogonality of an input segment with respect to a drafting axis of another input segment;

  ◦ grouping the segments of the explored pair if the first disparity is lower than the first predefined threshold or if the second disparity is lower than the second predefined threshold;

- the value of the draft-detection objective function for an input segment is a smallest eigenvalue of a normal matrix of the input segment; and/or the value of the draft-closing objective function is a smallest eigenvalue of a matrix that is a weighted sum of a normal matrix of the other input segment and the identity minus a normal matrix of the input segment, the sum being weighted based on the areas of the input segments;
- the first disparity is of the type

$$\delta(S_1, S_2) = \lambda_{S_1 \sqcup S_2}^m - \frac{\mathcal{A}_{S_1}}{\mathcal{A}_{S_1} + \mathcal{A}_{S_2}} \lambda_{S_1}^m - \frac{\mathcal{A}_{S_2}}{\mathcal{A}_{S_1} + \mathcal{A}_{S_2}} \lambda_{S_2}^m,$$

where $S_1$ and $S_2$ are the two segments of the explored pair, $\lambda_{S_1 \sqcup S_2}^m$ is the smallest eigenvalue of the normal matrix $\tilde{T}_{S_1 \cup S_2}$ of the union of $S_1$ and $S_2$, $\lambda_{S_1}^m$ is the smallest eigenvalue of the normal matrix $\tilde{T}_{S_1}$ of $S_1$, $\lambda_{S_2}^m$ is the smallest eigenvalue of the normal matrix $\tilde{T}_{S_2}$ of $S_2$ if $S_2$ has a non-zero draft angle and the smallest eigenvalue of the normal matrix $T_{S_2}$ of $S_2$ if $S_2$ has a zero draft angle, where

$$\widetilde{\mathbf{T}}_{S_1 \sqcup S_2} = \frac{\mathcal{A}_{S_1}}{\mathcal{A}_{S_1} + \mathcal{A}_{S_2}} \widetilde{\mathbf{T}}_{S_1} + \frac{\mathcal{A}_{S_2}}{\mathcal{A}_{S_1} + \mathcal{A}_{S_2}} \widetilde{\mathbf{T}}_{S_2}$$

$$+ \frac{\mathcal{A}_{S_1}}{\mathcal{A}_{S_1} + \mathcal{A}_{S_2}} \frac{\mathcal{A}_{S_2}}{\mathcal{A}_{S_1} + \mathcal{A}_{S_2}} \left( \overline{n_{S_1}} - \overline{n_{S_2}} \right) \left( \overline{n_{S_1}} - \overline{n_{S_2}} \right)^T$$

when $S_1$ and $S_2$ having non-zero draft angles,

$$\mathcal{A}_{S_1}$$

being the area of $S_1$,

$$\mathcal{A}_{S_2}$$

being the area of $S_2$, and

$$\widetilde{\mathbf{T}}_{S_1 \sqcup S_2} = \frac{\mathcal{A}_{S_1}}{\mathcal{A}_{S_1} + \mathcal{A}_{S_2}} \widetilde{\mathbf{T}}_{S_1} + \frac{\mathcal{A}_{S_2}}{\mathcal{A}_{S_1} + \mathcal{A}_{S_2}} \mathbf{T}_{S_2}$$

when $S_1$ has a non-zero draft angle and $S_2$ has a zero draft angle,

$$\mathcal{A}_{S_1}$$

being the area of $S_1$,

$$\mathcal{A}_{S_2}$$

being the area of $S_2$; and/or
the second disparity is of the type:

$$\delta_\perp(S_1, S_2) = \lambda^m_{S_1 \perp S_2} - \frac{\mathcal{A}_{S_1}}{\mathcal{A}_{S_1} + \mathcal{A}_{S_2}} \lambda^m_{S_1} - \frac{\mathcal{A}_{S_2}}{\mathcal{A}_{S_1} + \mathcal{A}_{S_2}} \lambda^m_{S_2},$$

where $\lambda^m_{S_1 \perp S_2}$ is the smallest eigenvalue of the matrix

$$\mathbf{T}_{S_1 \perp S_2} = \frac{\mathcal{A}_{S_1}}{\mathcal{A}_{S_1} + \mathcal{A}_{S_2}} \widetilde{\mathbf{T}}_{S_1} + \frac{\mathcal{A}_{S_2}}{\mathcal{A}_{S_1} + \mathcal{A}_{S_2}} \left( \mathbf{I} - \mathbf{T}_{S_2} \right)$$

where $S_1$ is the other input segment and $S_2$ is the input segment, $\lambda^m_{S_1}$ is the smallest eigenvalue of the normal matrix $\widetilde{\mathbf{T}}_{S_1}$ of $S_1$, and $\lambda^m_{S_2}$ is the smallest eigenvalue of the normal matrix $\mathbf{T}_{S_2}$ of $S_2$;
with $\mathbf{T}_{S_2}$ being an uncentered normal matrix of $S_2$ defined as

$$\boldsymbol{T}_{S_2} = \frac{1}{|S_2|} \int_{S_2} nn^T \, dvol_{S_2}$$

where denotes a normal vector and $|S_2|$ is a surface area of $S_2$;
- for each respective group, determining the CAD volume draft operator corresponding to the respective group includes building a profile curve of the respective group;
- building the profile curve comprises for each segment of the respective group, providing a respective profile curve of the segment; and iteratively concatenating the respective profile curves, where a pair of respective profile curves are concatenated if a third disparity between the respective profile curves of the pair is smaller than a third predefined threshold;
- for each respective group, determining the CAD volume draft operator corresponding to the respective group further includes determining a draft type of the CAD volume draft operator based on the built profile curve; and/or
- determining the draft type comprises:

◦ determining whether the profile curve is closed or not; and

◦ computing a total curvature of the profile curve,

where:

◦ the CAD volume draft operator is a draft surface if the profile curve is open and the absolute value of the total curvature is strictly smaller than $2\pi$, the CAD volume draft operator is a pad operator if the profile curve is closed and the total curvature equals $\beta 2\pi$, and

◦ the CAD volume draft operator is a pocket operator if the profile curve is closed and the total curvature equals $-\beta 2\pi$,

where $\beta \in \{-1, 1\}$; wherein optionally the total curvature is of the type:

$$\kappa_{tot} = \int_I \kappa_\gamma(t)\,dt$$

where $\kappa_\gamma(t)$ is the algebraic curvature of the curve $\gamma$ at parameter $t$.

It is further provided a computer program comprising instructions for performing the method.

It is further provided a computer readable storage medium having recorded thereon the computer program.

It is further provided a system comprising a processor coupled to a memory, the memory having recorded thereon the computer program.

## BRIEF DESCRIPTION OF THE DRAWINGS

Non-limiting examples will now be described in reference to the accompanying drawings, where:

- FIG. 1 shows an example of a graphical user interface of the system;
- FIG. 2 shows an example of the system; and
- FIG.s 3-12 show examples of the method.

## DETAILED DESCRIPTION

It is proposed a computer-implemented method for CAD volume draft operator detection in a discrete 3D model. The discrete 3D model represents a mechanical part. The method comprises obtaining a segmentation of the discrete 3D model. The discrete 3D model includes a skin. The skin represents an outer surface of the mechanical part. The segmentation comprises segments. Each segment represents a skin portion. The method further comprises iteratively grouping segment. In the grouping, two segments of a pair of segments are grouped if each segment of the pair is a drafted surface and both segments have a same respective drafting axis, and both segments have a same respective draft angle relative to the respective drafting axis. Alternatively, in the grouping, two segments of a pair of segments are grouped if each segment of the pair is a drafted surface and both segments have a same respective drafting axis, and at least one segment has a zero angle relative to the respective drafting axis. Further alternatively, in the grouping, two segments of a pair of segments are grouped if one segment of the pair is a drafted surface and the other segment is a closing plane. In the grouping, at least one iteration groups a pair of segments with at least one segment having a non-zero draft angle relative to the respective drafting axis. The method further comprises determining one or more CAD volume draft operators. Each CAD volume draft operator corresponds to a respective group.

The method forms an improved solution for CAD 3D model processing.

Notably, the method allows for CAD volume draft operator detection in a discrete CAD 3D model, *i.e.* the method detects one or more CAD volume draft operators in a provided (i.e., obtained) discrete 3D model. Detection of a CAD volume draft operator allows to detect/compute a contour of the volume on which a draft volume has been applied. This provides further meaningful characteristics about the mechanical part. For example, detection of these operators allows to distinguish between CAD Pocket features and/or CAD Pad features. Detection of CAD volume draft operator altogether enables an improved understanding of material distribution in the mechanical part and of the operators building this distribution. Detection of CAD volume draft operator is particularly relevant in mechanical CAD/manufacturing CAD, as further explained hereinafter.

Furthermore, not only does the method detect CAD volume draft operators, but the method does so in an improved manner. Indeed, the method starts from an obtained segmentation of the discrete 3D model and then groups iteratively segments of the segmentation, *i.e.* the method iteratively explores segments and groups explored segments. Two segments of a pair of segments are grouped in three cases. The first case is if they both are a drafted surface (i.e., a surface produced upon an application of a draft operator) and both segments have a same respective drafting axis and a same respective draft angle relative to the respective drafting axis. In such cases, a union of the two segments is a draft surface with the same draft angle as that of the two segments with respect to said drafting axis. In other words, if the two segments are part of a same drafted volume (also referred to as "draft volume") and have a same draft angle with respect to a same drafting axis. The union (e.g., of two segments) is to be understood mathematically, as the mathematical union of two sets. The second case is if they both are a drafted surface and both segments have a same respective drafting axis while at least one segment has a zero angle relative to the respective drafting axis. As known, a draft operator with a zero draft angle is equivalent to an extrusion operator when said extrusion is respective to the drafting axis as its extrusion axis. Therefore, in the second case, two segments are grouped if they are two draft surfaces with different draft angles with respect to a same drafting axis and at least one said angles is zero. The third case is if one of them is a drafted surface and one of them is a closing plane for the other, *i.e.* said other is a part of a drafted volume closed by the closing plane.

Thereby, by iteratively grouping segments based on such considerations, the method ultimately (*i.e.* once all iterations are done) obtains groups of segments, each group corresponding to a respective drafted volume, *i.e.* the segments of a respective group altogether form a respective drafted volume. Then for each group, a CAD volume draft operator corresponding to the group, *i.e.* corresponding to the volume draft formed by the group, is determined. By grouping the segments this way, the method then determines one or more CAD volume draft operators each fitting a respective group. This allows to determine the CAD volume draft operators with efficiency and generality, as the method relies on drafting axis similarity detection and closing plane detection to obtain the groups. Furthermore, this determination is computationally efficient.

The method is thereby not limited to the detection of specific types of drafted volumes and detects any CAD volume draft operator, regardless of its type or of its profile. In other words, the grouping performed by the method enables the detection of any CAD volume draft operator in the CAD 3D model. In yet other words, the method determines any CAD volume draft operators, with arbitrary profiles. The method may indeed detect CAD volume draft operators having canonical profiles (*e.g.*, conical surfaces) as well as CAD volume draft operators having free-form profiles. By a canonical profile it is meant that said profile is a concatenation of one or more straight line segments and/or circular arcs. By a free-form profile it is meant that said profile includes at least one curve portion that is not a straight-line segment or a circular arc.

As previously explained, detection of CAD volume draft operator is particularly relevant in manufacturing CAD/mechanical CAD. Manufacturing CAD designates software solutions to assist design processes and manufacturing process, whereby the objective is to produce a physical product corresponding to a designed CAD 3D model. "Designing a manufacturing product/mechanical part/mechanical product" designates any action or series of actions which is at least a part of a process of elaborating a modeled object (3D or 2D) of the manufacturing product/mechanical part/mechanical product. The method may form such a process or may form at least a part of the process Within this context, the CAD model represents a manufacturing product (which is a mechanical part), that may be manufactured downstream to its design (*e.g.* with a design process that includes the method). The method may thus be included in such a manufacturing CAD process that includes a design process (*i.e.* of the mechanical part represented by the CAD 3D model) and/or manufacturing process (*i.e.* of the mechanical part upon completion of its design by editions of the CAD 3D model). A CAD volume draft operator allows and facilitates the edition of a corresponding volume portion of the CAD model, for example by modifying the parameters associated with the operator (*e.g.* the angle of the draft). The manufacturing CAD process including the method may further comprise a step of editing the CAD 3D model based on the detected CAD volume draft operator(s). Furthermore, such an operator further facilitates manipulating and storing 3D modeled objects in a design and fabrication process as a parameterized CAD model which requires much less memory, compared to discrete models (e.g., meshes or point clouds), to be stored on or to be loaded during a respective design software execution.

The method may for example form or be a part of a step of CAD feature obtention within the design process, which may be a step of feature-tree construction, that is a step of construction of a tree of CAD features underlying the CAD model. The concept of feature-tree is well known in manufacturing CAD. Within these steps, based on segments of the segmentation, some of which being draft surfaces each associated with a drafting axis, the method groups segments into draft volumes and determines a respective CAD volume draft operator for each draft volume. In other words, the method takes as input draft surfaces (*i.e.* some of the segments) and outputs CAD draft features (*i.e.* the determined CAD volume draft operators). These CAD features obtained by the method may be integrated into a feature-tree, *e.g.* along with other CAD features obtained by other methods (*e.g.* executed before, after, or during execution of the method in the CAD feature obtention step). The step of CAD feature obtention may thus result in a list of CAD features, e.g. arranged in a feature-tree, including the CAD volume draft operators determined by the method.

In the method, each determined CAD volume draft operator corresponds to (*e.g.* fits, builds) a respective group of segments, the latter being a draft volume. Each such draft volume is a volume which has a coherent geometry (*i.e.* that of a drafted volume, such as a pad, a pocket, or a split) and which is coherent from the point of view of the manufacturing. In other words, the portion of the mechanical part which corresponds to the draft volume has a geometry/shape requiring and/or adapted to a respective manufacturing process (*e.g.* molding). The detection of a CAD volume draft corresponding to this portion, that the method allows, enables to perform editions, downstream to the method, *e.g.* within the previously mentioned design process, of the corresponding portion of the CAD 3D model (*i.e.* the corresponding group of segments) in view of this manufacturing process. In examples of the method wherein the mechanical part is to be manufactured via a molding process, the method may form or be a part of a design and manufacturing process to set a draft angle of a mold to be used in said molding process. In such examples, upon the detection of one or more draft operators in the input discrete model, the design of the mechanical part and notably the draft angle of said detected draft operator may be updated so as to improve demolding of said mechanical part. The method and/or the design and manufacturing process may notably further comprise editing one or more (*e.g.* all) of the detected CAD volume draft operator so as to set, for each edited operator, a respective draft angle that facilitates demolding of the part, as known *per* se from molding manufacturing. Because the method provides for draft operators facilitating editions of the model, the draft angles can be set or modified more efficiently and reliably.

Notably, such a method aids designers and engineers in the process of designing. It is very common in engineering fields to perform a design process based on a provided discrete 3D model, for example a mesh (e.g., a polygonal mesh) or a point cloud without having access to a respective CAD file of said provided discrete 3D model. Such a discrete 3D model may be retrieved from an in-house database or downloaded from an online library. Alternatively or additionally, such a discrete 3D model may be obtained from a topology optimization method. As known, topology optimization methods may provide a (e.g., voxel) mesh of a final design based on values of a material density function. Further alternatively or additionally, such a discrete 3D model which is stored in a database, may be a discrete 3D model generated/outputted by a software package which is no longer available to the designer. Yet further alternatively or additionally, such a discrete 3D model which may be stored in a database, may be a discrete 3D model generated/outputted as an output by a scanning process.

In examples, the method may obtain the discrete 3D model via a 3D scanning process. In other words, the method may comprise, prior to obtaining the discrete 3D model, a scanning process on a real-world sample of a mechanical product. The scanning process may output a point cloud or a mesh representing said mechanical part. The method may convert a point cloud to a mesh. In such examples, the method may form or be a part of a process to obtain a CAD model of a physical object via a scanning process. In such applications, the method may detect a volume (or part of a volume) corresponding to a draft operator. Such applications may relate to detecting a draft angle (or a plurality of draft angles) from a 3D scanning process, for example to obtain respective parameters of an adequate mold with said detected draft angles. Such a mold may be particularly relevant to fabricate a copy from a measured prototype or preparing a mass production stage. Such applications are particularly relevant to reverse engineering using a sample of a physical object while having no access to fabrication details of said object. For example, the method may be used to fabricate a mockup of an already existing manufacturing product.

The method is now further discussed.

The method is for CAD draft operator detection in a discrete 3D model representing a mechanical part. In other words, the method, based on the discrete 3D model, detects one or more CAD volume draft operators in the discrete 3D model. A CAD volume draft operator, which may also be referred to as a "CAD volume draft feature" or simply "CAD draft feature," is a CAD operator that corresponds to a bending of one or more faces on a part relatively to a neutral face. A CAD draft operator is defined by a draft angle (with respect to a drafting axis $u_e$) and a neutral face. Said draft angle sets an angle for said bending of the draft. Said drafting axis corresponds to said neutral face, for example the drafting axis may be normal to the neutral face. The drafting axis is defined by its direction and the neutral face defines the height from which the surface must be bent. The drafting axis may be normal to the neutral face. Such an operator defines a drafted volume, *i.e.*, a volume defined as the result of the application of the CAD draft operator. In other words, the CAD volume draft operator defines a drafted volume as the result of the application of one or more parameters (*e.g.* a profile curve, a drafting axis, height limits, and a type such as Pad or Pocket) defining the operator. The drafted volume is a 3D volume portion of the CAD model that is shaped as a drafted extrusion, and corresponds to a distribution of material of the mechanical part arranged as a drafted extrusion. The volume is partially formed by the aggregation of draft surfaces having a same draft axis, and possibly of a closing plane. In addition to said drafting axis and angle, a CAD volume draft operator may be defined by: a (planar) profile curve $\gamma$, height limits $h_{min}$, $h_{max}$, and a type (Pad or Pocket).

The method comprises obtaining a segmentation of the discrete 3D model.

The obtaining of the segmentation may comprise providing an already existing segmentation of the 3D model, for example by retrieving this existing segmentation from a (*e.g.* distant) memory or database where it has been stored further to its obtention. The segmentation may be the segmentation resulting from a method for segmenting a 3D modeled object described in European Patent Application EP21305195.6 filed on 16 February 2021 by Dassault Systèmes, which is incorporated herein by reference. In other words, the provided segmentation of the discrete 3D model may be the segmentation (*i.e.* the set of first and second segments) resulting from the method for segmenting a 3D modeled object described in European Patent Application EP21305195.6 when applied to the 3D modeled object that is a discrete 3D model. Alternatively, the segmentation may be the segmentation that results from the performing of a segmentation according to the method of use described in European Patent Application EP21305293.9 filed on 10 March 2021 by Dassault Systèmes, which is incorporated by reference. In other words, the provided segmentation of the discrete 3D model may be the segmentation resulting from the performing of a segmentation according to the method of use described in European Patent Application EP21305293.9 when applied to the 3D modeled object that is a discrete 3D model. Yet alternatively, the segmentation may be any other segmentation of the CAD 3D model, resulting from another segmentation method.

Alternatively, the obtaining of the segmentation of the discrete 3D model may comprise providing said model (*e.g.* by retrieving it from a memory or database) and then performing a segmentation of the discrete 3D model. The performing of a segmentation of the discrete 3D model may comprise applying to the CAD 3D model the method for segmenting a 3D modeled object described in previously-cited European Patent Application EP21305195.6 (*i.e.* the discrete 3D model playing in this case the role of the 3D modeled object in the method described in previously-cited European Patent Application EP21305195.6). Alternatively, the performing of a segmentation of the discrete 3D model may comprise applying to the discrete 3D model the method of use described in previously-cited European Patent Application EP21305293.9 (*i.e.* the CAD 3D model playing in this case the role of the 3D modeled object in the method of use described in previously-cited European Patent Application EP21305293.9). In this case the segmentation is the result of the step of performing a segmentation according in the method of use described in previously-cited European Patent Application EP21305293.9 when applied to a discrete 3D model. Yet alternatively, the performing of a segmentation of the CAD 3D model may comprise applying any other method of segmentation.

In any case, the segmentation comprises segments, the segments altogether forming the segmentation. Each segment represents (*e.g.* is) a skin portion, *i.e.* a portion of the skin. In other words, each segment corresponds to (*e.g.* is) a portion of the outer surface of the discrete 3D model. Being a segment of a segmentation, each segment is a geometrically coherent surface portion of the 3D modeled object (*e.g.* a draft surface), having a maximal inner consistency.

Further to the providing of the segmentation of the CAD 3D model, the method then comprises iteratively grouping segments. In other words, the method iteratively visits/explores/browses segments and groups them. Exploring may consist in browsing a list of the segments. The grouping is based on the criterion to group two segment of a pair of segments (a pair of segments always consisting in two segments) if:

- each segment of the pair is a drafted surface and both segments have a same respective drafting axis, and:

  - both segments have a same respective draft angle relative to the respective drafting axis, or
  - at least one segment has a zero angle relative to the respective drafting axis; or

- one segment of the pair is a drafted surface and the other segment is a closing plane.

The method may iteratively assess whether pairs of segments verify the criterion, and group the segments of a pair when they verify the criterion. The criterion is notably based on segments being draft surfaces. The mechanical part has at least one drafted surface with non-zero draft angle. Thereby, at least one iteration groups a pair of segments with at least one segment having a non-zero draft angle relative to the respective drafting axis.

In examples, the method may comprise determining all segments that are drafted surfaces. In such example, the determining may include performing a test of whether

$$\exists u \in \mathbb{R}^3 \setminus \{(0,0,0)\}, \theta \in \mathbb{R}^3 : \ \forall p \in S, \quad n_p \cdot u = \boldsymbol{sin(\theta)},$$

where $S$ is a segment and $n_p$ is the normal vector to the segment $S$ at point $p$. The method then determines that, each surfaces which satisfies the test, is a drafted surfaces. Such a determined drafted surface is defined with respect to the drafting axis u with a drafting angle $\theta$. Such a determining may be prior to the iterative grouping. In other words, prior to the iterative grouping, the method may detect which segments are draft surface. The results of this detection may be stored in a memory, *e.g.* the method may label the segments detected to be draft surfaces and store the labels with their associated segments.

In the iterative grouping of segments, the method may thereby iteratively explore pairs of segments of which segments are detected (*e.g.* labelled) to be draft surfaces. A closing plane of a volume draft is a portion (*i.e.* a segment) of the drafted volume that is a plane which is orthogonal to the drafting axis of said volume.

Grouping two segments may comprise associating together the two segments, and marking them (*e.g.* labelling them) as being part of the same group. Grouping two segments may in some cases further comprise merging the two segments, thereby creating a new segment. Specifically, the method may merge two segments when each segment of the pair is a drafted surface and both segments have a same respective drafting axis, and both segments have a same respective draft angle relative to the respective drafting axis.

The method may perform the test of determining all segments that are drafted surfaces using different approaches. In examples, the performing of the test may comprise evaluating, for each segment $S$:

$$\exists u \in \mathbb{R}^3: |u| = 1 \ \text{ and } \ \mathcal{J}_S(u) \le \epsilon$$

where $\mathcal{J}_S: \mathbb{R}^3 \longrightarrow \mathbb{R}_+$ and is defined by:

$$\mathcal{J}_S(u) = \frac{1}{\mathcal{A}_S} \int_S \left( u \cdot \left( n_p - \bar{n} \right) \right)^2 dvol_S$$

$$\mathcal{A}_S = \int_S dvol_S$$

and $vol_s$ is the canonical measure on $S$. $\epsilon > 0$ represents a sufficiently small (e.g., 0.001) threshold and $\bar{n}$ is the mean normal of $S$ defined as $\bar{n} = \frac{1}{|S|} \int_S n \, dvol_S$.

In examples, the evaluation may comprise solving an optimization problem of the type:

$$\min_{u \in \mathbb{R}^3} \ u^T \widetilde{\mathbf{T}}_S u$$
$$s.t. \ |u| = 1$$

where $\widetilde{\mathbf{T}}_S$ is of the type:

$$\widetilde{\mathbf{T}}_S = \frac{1}{\mathcal{A}_S} \int_S (n - \bar{n})(n - \bar{n})^T dvol_S.$$

In examples, the solving of the optimization problem comprises finding the smallest eigenvalue of (the matrix) $\widetilde{\mathbf{T}}_S$ as well as its associated eigenvector $u_S^m$. The (performing of the) testing may comprise testing if $\lambda_S^m \le \epsilon$. Here $\lambda_S^m$ is the smallest eigenvalue.

In examples, the iteratively grouping segments may comprise one or more iterations of an iterative process. The iterative process may explore a pair of segments. In other words, the method may explore at least part of (e.g., all) of the segments of the obtained segmentation in pair-wise fashion. The method may determine whether a first disparity between the value of a draft-detection objective function for a union of the segments of the explored pair and a weighted sum of the values of the draft-detection objective function for the segments of the explored pair is lower than a first predefined threshold. The (weighted) sum may be weighted based on the areas of the (pair of) segments. Examples of said first disparity are discussed below. The method may alternatively determine whether a second disparity between the value of a draft-closing objective function for the segments of the explored pair and the weighted sum is lower than a second predefined threshold. The draft-closing objective function may reward orthogonality of an input segment with respect to a drafting axis of another input segment. Examples of said second disparity are discussed below. The method then may regroup the segments of the explored pair if the first disparity is lower than the first predefined threshold. The method may alternatively regroup the segments of the explored pair if the second disparity is lower than the second predefined threshold.

The first disparity is between the value of the draft-detection objective function for a union of the segments and a weighted sum of the values of the draft-detection objective function for the two segments of the pair (i.e. a weighted sum of the two respective values of the draft-detection objective function for two segments of the pair). The first disparity is any function that tends to vanish when the union is a draft surface having as draft axis the same draft axis than that of the two segments, i.e. when the value of the draft-detection objective function tends to equal the weighted sum. The disparity may for example be a difference between the value of the draft-detection objective function for the union and the weighted sum of the values of the function for the two segments.

The draft-detection objective function may be any function that allows detection of a draft surface, e.g. by vanishing (or tending to vanish) for an input draft in which case verifying smallness of the value of the draft-detection objective function for an input surface amounts to verify that the surface is a draft surface. Such a function may for example be a function that rewards a constant angle between a candidate draft axis of an input surface and a normal vector to the input surface. In examples, such a function may reward an orthogonality between a candidate draft axis of an input surface and a different between a normal vector to the input surface and an average normal vector over said surface. In such examples, the objective function may tend to vanish when there is such orthogonality. Verifying that this function has a value smaller than a predefined draft-detection threshold corresponds to verifying that the candidate draft axis is indeed a draft axis of the input surface, which is then a draft surface.

The second disparity is between the value of the draft-closing objective function for the segment of the explored pair and the weighted sum (*i.e.* the weighted sum of the values of the draft-closing objective function for the segments of the explored pair). The second disparity is any function that tends to vanish when one of the segments is a closing plane for the other segment, *i.e.* when the value of the draft-closing objective function tends to equal the weighted sum. The disparity may be for example a difference between the value of the draft-closing function for the explored pair and the weighted sum.

The draft-closing objective function is any function that allows detection that an input draft surface is a closing plane for another input draft surface, *e.g.* by vanishing (or tending to vanish) for these inputs in which case verifying smallness of the value of the draft -closing objective function for these inputs amounts to verify that one of the inputs is a closing plane for the other input. For that, the draft -closing objective function is a function that rewards orthogonality of an input segment with respect to a draft axis of another input segment, *e.g.* by tending to vanish when there is such orthogonality, such that verifying that this function has a value smaller than a predefined draft-closing threshold corresponds to verifying that an input draft surface is indeed a closing plane for the other input draft surface.

The first threshold and the second threshold are both predefined, i.e. are defined beforehand, *e.g.* at an initial stage of the method. The first threshold may equal the second threshold. The first threshold and/or the second threshold may be defined by a user.

The value of the draft-detection objective function for an input segment may be a smallest eigenvalue of a normal matrix of the input segment. Alternatively or additionally the value of the draft-closing objective function may be a smallest eigenvalue of a matrix that is a weighted sum of a normal matrix of the other input segment and the identity minus a normal matrix of the input segment. The (weighted) sum may be weighted based on the areas of the input segments.

In examples, the first disparity may be of the type:

$$\delta(S_1, S_2) = \lambda_{S_1 \sqcup S_2}^m - \frac{\mathcal{A}_{S_1}}{\mathcal{A}_{S_1} + \mathcal{A}_{S_2}} \lambda_{S_1}^m - \frac{\mathcal{A}_{S_2}}{\mathcal{A}_{S_1} + \mathcal{A}_{S_2}} \lambda_{S_2}^m,$$

where $S_1$ and $S_2$ are the two segments of the explored pair, $\lambda_{S_1 \sqcup S_2}^m$ is the smallest eigenvalue of the normal matrix $\tilde{\mathbf{T}}_{S_1 \cup S_2}$ of the union of $S_1$ and $S_2$, and $\lambda_{S_1}^m$ is the smallest eigenvalue of the normal matrix $\tilde{\mathbf{T}}_{S_1}$ of $S_1$.

Furthermore, $\lambda_{S_2}^m$ is the smallest eigenvalue of the normal matrix $\tilde{\mathbf{T}}_{S_2}$ of $S_2$ if $S_2$ has a non-zero draft angle. In examples where the segment $S_2$ has a zero draft angle (i.e., where said segment is an extrusion), $\lambda_{S_2}^m$ is the smallest eigenvalue of the normal matrix $\mathbf{T}_{S_2}$ of $S_2$. Here the matrix $\mathbf{T}_{S_2}$ is an uncentered normal matrix of $S_2$ defined as

$$\mathbf{T}_{S_2} = \frac{1}{|S_2|} \int_{S_2} nn^T dvol_{S_2}$$

where denotes a normal vector and $|S_2|$ is a surface area of $S_2$.

Furthermore, the matrix $\tilde{\mathbf{T}}_{S_1 \cup S_2}$ is defined as

$$\widetilde{\mathbf{T}}_{S_1 \sqcup S_2} = \frac{\mathcal{A}_{S_1}}{\mathcal{A}_{S_1} + \mathcal{A}_{S_2}} \widetilde{\mathbf{T}}_{S_1} + \frac{\mathcal{A}_{S_2}}{\mathcal{A}_{S_1} + \mathcal{A}_{S_2}} \widetilde{\mathbf{T}}_{S_2} + \frac{\mathcal{A}_{S_1}}{\mathcal{A}_{S_1} + \mathcal{A}_{S_2}} \frac{\mathcal{A}_{S_2}}{\mathcal{A}_{S_1} + \mathcal{A}_{S_2}} \left( \overline{n_{S_1}} - \overline{n_{S_2}} \right) \left( \overline{n_{S_1}} - \overline{n_{S_2}} \right)^T$$

when $S_1$ and $S_2$ having non-zero draft angles,

$$\mathcal{A}_{S_1}$$

being the area of $S_1$,

$$\mathcal{A}_{S_2}$$

being the area of $S_2$, and

$$\widetilde{\mathbf{T}}_{S_1 \sqcup S_2} = \frac{\mathcal{A}_{S_1}}{\mathcal{A}_{S_1} + \mathcal{A}_{S_2}} \widetilde{\mathbf{T}}_{S_1} + \frac{\mathcal{A}_{S_2}}{\mathcal{A}_{S_1} + \mathcal{A}_{S_2}} \mathbf{T}_{S_2}$$

when $S_1$ has a non-zero draft angle and $S_2$ has a zero draft angle,

$$\mathcal{A}_{S_1}$$

being the area of $S_1$,

$$\mathcal{A}_{S_2}$$

being the area of $S_2$.

In examples, the second disparity may be of the type:

$$\delta_\perp(S_1, S_2) = \lambda^m_{S_1 \perp S_2} - \frac{\mathcal{A}_{S_1}}{\mathcal{A}_{S_1} + \mathcal{A}_{S_2}} \lambda^m_{S_1} - \frac{\mathcal{A}_{S_2}}{\mathcal{A}_{S_1} + \mathcal{A}_{S_2}} \lambda^m_{S_2},$$

where $\lambda^m_{S_1 \perp S_2}$ is the smallest eigenvalue of the matrix

$$\mathbf{T}_{S_1 \perp S_2} = \frac{\mathcal{A}_{S_1}}{\mathcal{A}_{S_1} + \mathcal{A}_{S_2}} \widetilde{\mathbf{T}}_{S_1} + \frac{\mathcal{A}_{S_2}}{\mathcal{A}_{S_1} + \mathcal{A}_{S_2}} (\mathbf{I} - \mathbf{T}_{S_2})$$

where $S_1$ is the other input segment and $S_2$ is the input segment. Here $\lambda^m_{S_1}$ is the smallest eigenvalue of the normal matrix $\widetilde{\mathbf{T}}_{S_1}$ of $S_1$, and $\lambda^m_{S_2}$ is the smallest eigenvalue of the normal matrix $\mathbf{T}_{S_2}$ of $S_2$.

The determining of the CAD volume draft operator corresponding to each respective group may include building a profile curve of the respective group. Building the profile curve may be based on the profile curves of the segments in the respective group. For example, building the profile curve may comprise, for each segment of the respective group, providing a respective profile curve of the segment. In this case, building the profile curve further comprises iteratively concatenating the respective profile curves, where a pair of respective profile curves are concatenated if a disparity between the respective profile curves of the pair is smaller than a third predefined threshold.

The providing of the respective profile curves of each segment of the group may comprise retrieving these profile curves from a (*e.g.* distant memory) where they have been stored further to their computation. These profile curves may for example each be a profile curve obtainable (*e.g.* having been obtained) by the method of parameterization described in European Patent Application EP21305671.6 filed on 21 May 2021 by Dassault Systèmes. Alternatively, the providing of the respective profile curves of each segment of the group may comprise applying obtaining these profile curves. For example, this may comprise applying the method of parameterization described in previously-cited European Patent Application EP21305671.6. In other words, for each segment of the group, the providing of the respective profile curve of the segment may comprise applying the method of parameterization described in previously-cited European Patent Application EP21305671.6 including the step of computing a profile described in European Patent Application EP21305671.6, this application yielding a profile curve of the segment.

When the profile curves are obtained or obtainable by the previously-mentioned method described in previously-cited European Patent Application EP21305671.6, the profile curves are parametrized with a natural parameterization, that grows along a profile direction, as described in European Patent Application EP21305671.6. For example, the parameterization of such profile curve may be an arclength parametrization that grows along the profile direction. The concatenation builds the profile curve of the drafted volume that is the group from the profile curves of its segments, and using the parameterization provided by European Patent Application EP21305671.6 allows to obtain an orientation-coherent parameterization of the profile curve of the drafted volume.

Iteratively concatenating the respective profile curves comprises iteratively joining the profile curves (*i.e.* one by one) to form a single profile curve which is that of the respective group. The iterative concatenating comprises concatenating two by two the profile curves, *i.e.* concatenating pairs of profile curves, where for each pair of profile curves, the profile curves are concatenated if a third disparity between the respective profile curves of the pair is smaller than a third predefined threshold. The third disparity may be any function, such as a distance, that vanishes when the respective profile curves can be concatenated (*e.g.* when they can be joined using their extremal points).

The third predefined threshold may be defined by a user, *e.g.* beforehand, at an initial stage of the method. When the CAD 3D object is measured (*e.g.* scanned as previously discussed), the third predefined threshold may be defined with respect to a noise associated with the measurement, *e.g.* the third predefined threshold may be proportional or substantially proportional to the noise. This provides robustness to noise. The method may use an implementation as discussed in European Patent Application EP21306184.9, filed on 31 August 2021 by Dassault Systèmes, which is incorporated by reference.

For each respective group, determining the CAD volume draft operator corresponding to the respective group may further include determining a draft type of the CAD volume draft operator based on the built profile curve. The type of the CAD volume draft operator may be a pad operator, which corresponds to an addition of material by sliding the profile curve along the drafting axis in an outward direction. The type of the CAD volume draft operator may alternatively be a pocket operator, which corresponds to a removal of material by sliding the profile curve along the drafting axis in an inward direction. The method obtains the type of the CAD volume draft operator by using the profile curve built for the corresponding group, e.g. by assessing closeness or non-closeness of the profile curve and a curvature of the profile curve, these characteristics of the curve determining the draft type.

Determining the draft type may comprise determining whether the profile curve is closed or not and computing a total curvature of the profile curve. In this case, the CAD volume draft operator is a draft surface (*e.g.* a split operator) if the profile curve is open and the absolute value of the total curvature is strictly smaller than $2\pi$. The CAD volume draft operator is a pad operator if the profile curve is closed and the total curvature equals $\beta.2\pi$. The CAD volume draft operator is a pocket operator if the profile curve is closed and the total curvature equals $-\beta.2\pi$, where $\beta \in \{-1, 1\}$. The number $\beta$ may be that of the previously discussed implementation of the building of the profile curve. The total curvature may be of the type:

$$\kappa_{tot} = \int_I \kappa_\gamma(t)dt$$

where $\kappa_\gamma(t)$ is the algebraic curvature of the curve $\gamma$ at parameter $t$, $t$ being an arclength parameter of an arclength parameterization of the curve $\gamma$ on interval $I$. Using the total curvature allows to take advantage of the orientation of the surface normals to determine the type. For example, an addition of material corresponds to an outwardly directed normal and a removal of material correspond to an inwardly directed normal. The determining of the draft type is according to the implementation. The method may use an implementation as discussed in European Patent Application EP21306184.9, filed on 31 August 2021 by Dassault Systèmes, which is incorporated by reference.

CAD concepts related to the method and/or to a context thereof are now discussed.

The method generally manipulates modeled objects, such as the finite CAD model outputted by the method. A modeled object is any object defined by data stored e.g. in the database. By extension, the expression "modeled object" designates the data itself. According to the type of the system, the modeled objects may be defined by different kinds of data. The system may indeed be any combination of a CAD system, a CAE system, a CAM system, a PDM system and/or a PLM system. In those different systems, modeled objects are defined by corresponding data. One may accordingly speak of CAD object, PLM object, PDM object, CAE object, CAM object, CAD data, PLM data, PDM data, CAM data, CAE data. However, these systems are not exclusive one of the other, as a modeled object may be defined by data corresponding to any combination of these systems. A system may thus well be both a CAD, CAE, PLM and/or CAM system, as will be apparent from the definitions of such systems provided below.

By CAD solution (e.g. a CAD system or a CAD software), it is additionally meant any system, software or hardware, adapted at least for designing a modeled object on the basis of a graphical representation of the modeled object and/or on a structured representation thereof (e.g. a feature tree), such as CATIA. In this case, the data defining a modeled object comprise data allowing the representation of the modeled object. A CAD system may for example provide a representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated.

Specifications of a modeled object may be stored in a single CAD file or multiple ones. The typical size of a file representing a modeled object in a CAD system is in the range of one Megabyte per part. And a modeled object may typically be an assembly of thousands of parts.

In the context of CAD, a modeled object may typically be a 2D or 3D modeled object, e.g. representing a product such as a part or an assembly of parts, or possibly an assembly of products. The 2D or 3D modeled object may be a manufacturing product, i.e. a product to be manufactured. By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D representation facilitates design (i.e. increases the speed at which designers statistically accomplish their task). This speeds up the manufacturing process in the industry, as the design of the products is part of the manufacturing process.

The 2D or 3D modeled object may represent the geometry of a product to be manufactured in the real world subsequent to the completion of its virtual design with for instance a CAD/CAE software solution or CAD/CAE system, such as a (e.g. mechanical) part or assembly of parts (or equivalently an assembly of parts, as the assembly of parts may be seen as a part itself from the point of view of the method, or the method may be applied independently to each part of the assembly), or more generally any rigid body assembly (e.g. a mobile mechanism). A CAD/CAE software solution allows the design of products in various and unlimited industrial fields, including: aerospace, architecture, construction, consumer goods, high-tech devices, industrial equipment, transportation, marine, and/or offshore oil/gas production or transportation. The 3D modeled object designed by the method may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

A CAD system may be history-based. In this case, a modeled object is further defined by data comprising a history of geometrical features. A modeled object may indeed be designed by a physical person (i.e. the designer/user) using standard modeling features (e.g. extrude, revolute, cut, and/or round) and/or standard surfacing features (e.g. sweep, blend, loft, fill, deform, and/or smoothing). Many CAD systems supporting such modeling functions are history-based system. This means that the creation history of design features is typically saved through an acyclic data flow linking the said geometrical features together through input and output links. The history-based modeling paradigm is well known since the beginning of the 80's. A modeled object is described by two persistent data representations: history and B-rep (i.e. boundary representation). The B-rep is the result of the computations defined in the history. The shape of the part displayed on the screen of the computer when the modeled object is represented is (e.g. a tessellation of) the B-rep. The history of the part is the design intent. Basically, the history gathers the information on the operations which the modeled object has undergone. The B-rep may be saved together with the history, to make it easier to display complex parts. The history may be saved together with the B-rep in order to allow design changes of the part according to the design intent.

By PLM system, it is additionally meant any system adapted for the management of a modeled object representing a physical manufactured product (or product to be manufactured). In a PLM system, a modeled object is thus defined by data suitable for the manufacturing of a physical object. These may typically be dimension values and/or tolerance values. For a correct manufacturing of an object, it is indeed better to have such values.

By CAE solution, it is additionally meant any solution, software of hardware, adapted for the analysis of the physical behavior of a modeled object. A well-known and widely used CAE technique is the Finite Element Model (FEM) which is equivalently referred to as CAE model hereinafter. An FEM typically involves a division of a modeled object into elements, i.e., a finite element mesh, which physical behaviors can be computed and simulated through equations. Such CAE solutions are provided by Dassault Systèmes under the trademark SIMULIA®. Another growing CAE technique involves the modeling and analysis of complex systems composed a plurality of components from different fields of physics without CAD geometry data. CAE solutions allow the simulation and thus the optimization, the improvement and the validation of products to manufacture. Such CAE solutions are provided by Dassault Systèmes under the trademark DYMOLA®. CAE may be used to ensure that various structural requirements (such as, but not limited to, mass, stiffness, strength, durability) are achieved by a new CAD model. Some of these requirements may be called Key Performance Indicators (KPIs). For many industrial products (for example cars, airplanes, consumer packaged goods, hi-tech), these KPIs are in conflict e.g. lower mass usually causes lower stiffness. Thus, optimization methods are often applied to find the best trade-off between the KPIs.

By CAM solution, it is meant any solution, software of hardware, adapted for managing the manufacturing data of a product. The manufacturing data generally include data related to the product to manufacture, the manufacturing process and the required resources. A CAM solution is used to plan and optimize the whole manufacturing process of a product. For instance, it may provide the CAM users with information on the feasibility, the duration of a manufacturing process or the number of resources, such as specific robots, that may be used at a specific step of the manufacturing process; and thus allowing decision on management or required investment. CAM is a subsequent process after a CAD process and potential CAE process. For example, a CAM solution may provide the information regarding machining parameters, or molding parameters coherent with a provided draft feature in a CAD model. Such CAM solutions are provided by Dassault Systèmes under the trademarks CATIA, Solidworks or trademark DELMIA®.

CAD and CAM solutions are therefore tightly related. Indeed, a CAD solution focuses on the design of a product or part and CAM solution focuses on how to make it. Designing a CAD model is a first step towards a computer-aided manufacturing. Indeed, CAD solutions provide key functionalities, such as feature based modeling and boundary representation (B-Rep), to reduce the risk of errors and the loss of precision during the manufacturing process handled with a CAM solution. Indeed, a CAD model is intended to be manufactured. Therefore, it is a virtual twin, also called digital twin, of an object to be manufactured with two objectives:

- checking the correct behavior of the object to be manufactured in a specific environment; and
- ensuring the manufacturability of the object to be manufactured.

PDM stands for Product Data Management. By PDM solution, it is meant any solution, software of hardware, adapted for managing all types of data related to a particular product. A PDM solution may be used by all actors involved in the lifecycle of a product: primarily engineers but also including project managers, finance people, salespeople and buyers. A PDM solution is generally based on a product-oriented database. It allows the actors to share consistent data on their products and therefore prevents actors from using divergent data. Such PDM solutions are provided by Dassault Systèmes under the trademark ENOVIA®.

The modeled object taken as input by the method is a (3D) discrete geometrical representation of a manufacturing product/mechanical product/mechanical part. The discrete geometrical representation is a data structure which comprises a discrete set of pieces of data. Each piece of data may specify an element of the product/mechanical part, and be referred to as a discrete element. The discrete geometrical representation may be 3D or alternatively 2D. Yet alternatively, the discrete geometrical representation may be both 3D and 2D, i.e. may comprise a 3D portion which is a 3D discrete geometrical representation and a 2D portion which is a discrete geometrical representation, such as a hybrid 3D-2D meshing (e.g. for modeling a product comprising both thin parts, modeled with the 2D portions, and thick parts, modeled with the 3D portions). The discrete geometrical representation may in examples comprise a number of such pieces of data higher than 100, 1000, or 10000.

In case of a 3D discrete geometrical representation, the 3D discrete geometrical representation may be a solid/volume 3D discrete geometrical representation of the product/mechanical part, such as a solid 3D finite element model (FEM) or a 3D volume mesh (e.g. a 3D tetrahedral mesh). In such a case, each piece of data may represent a respective geometrical entity positioned in a 3D space such that the pieces of data form a solid representation of the mechanical part/product (i.e., "solid 3D discrete geometrical representation"). Each geometrical entity may represent a respective location (i.e., a material point) of the 3D object (in other words, a respective portion of material constitutive of a solid represented by the 3D object). The aggregation (i.e., union or juxtaposition) of the geometrical entities represents altogether the 3D object as a solid/volume. The 3D discrete geometrical representation may alternatively be a skin 3D discrete geometrical representation, representing a skin of the product/mechanical part, such as a 3D surface mesh (e.g. a triangular surface mesh) or a tessellation. In such a case, each piece of data may represent a respective geometrical entity positioned in a 3D space, such that the pieces of data form a representation of the mechanical product's skin (i.e., "skin 3D discrete geometrical representation"). In such a case, each geometrical entity represents a respective location (i.e., a material point) on an outer surface of the 3D object (in other words, a respective portion of outer surface of the volume occupied by material constitutive of a solid represented by the object). The aggregation (i.e., union or juxtaposition) of the geometrical entities represents altogether at least part of the outer surface of the object.

In the case of a 2D discrete geometrical representation, each piece of data may represent a respective geometrical entity positioned in a 2D space. The 2D discrete geometrical representation may be a 2D finite element mesh or any 2D mesh. The discrete geometrical representation may be associated with one or more thickness value(s), for example a distribution of thickness value over its finite elements. Such a 2D discrete geometrical representation may for example represent a generally planar product, such as a stamping part (e.g., with a constant thickness value) or a composite material part (e.g., with different thickness values).

The modeled object outputted/designed by the method may be a CAD model, for example comprising or consisting in a feature tree and/or a B-rep. Such a model may stem from a CAE model and may results from a CAE to CAD conversion process, that the method may for example comprise at an initial stage.

The CAD model may be feature-based (e.g. it may comprise a feature tree, and optionally a corresponding B-rep obtained by executing the feature tree). A feature-based 3D model allows (e.g. during the determination of a manufacturing file or CAM file as discussed hereinafter) the detection and an automatic resolution of a geometry error in a CAD model such as a clash that will affect the manufacturing process. A clash is an interpenetration between two parts of a 3D model for example due to their relative motion. Furthermore, this clash may sometimes only be detected via a finite element analysis based on the CAD feature-based model. Therefore, a resolution of a clash can be performed with or automatically by the CAD solution by iteratively modifying the parameters of the features and doing a finite element analysis.

As another example, a feature-based 3D model allows (e.g. during the determination of a manufacturing file or CAM file as discussed hereinafter) an automatic creation of a toolpath for a machine via a computer numerical control (CNC). With CNC, each object to be manufactured gets a custom computer program, stored in and executed by the machine control unit, a microcomputer attached to the machine. The program contains the instructions and parameters the machine tool will follow. Mills, lathes, routers, grinders and lasers are examples of common machine tools whose operations can be automated with CNC.

A key characteristic of a CAD model is that it may be designed exactly and unambiguously by chaining a small number of high-level parameterized design operations (including for example, but to limited to, sketch, extrusion, chamfer) and edited by modifying its high-level parameters. That this is a key distinction with the polyhedral representations such as a triangular surface mesh which may represent any 3D shape but do not provide modification or parameterization capabilities required in an industrial design context.

As CAD model is a parameterized model of a part/product, it is lighter in terms of memory footprint than other models such as a CAE model. Indeed, instead of storing a collection of discrete geometrical elements such as finite elements, a CAD model allows the storing of a list of features and parameters, which is lighter in terms of storage and memory footprint. Working on CAD models thus reduced memory requirements for the underlying systems, as compared for example to CAE models, in addition to facilitate editability of the model. This amounts to say that a CAE to CAD conversion process in fact compresses the CAE model into a CAD model which is lighter in terms of memory requirements (e.g. footprint), in addition to transforming the CAE model into a more easily editable CAD model.

The generation of a custom computer program from CAD files may be automated. Such generation may therefore be errorproof and may ensure a perfect reproduction of the CAD model to a manufactured product. CNC is considered to provide more precision, complexity and repeatability than is possible with manual machining. Other benefits include greater accuracy, speed, and flexibility, as well as capabilities such as contour machining, which allows milling of contoured shapes, including those produced in 3D designs.

The B-rep (i.e. boundary representation) is a 3D representation of a mechanical part. Specifically, the B-rep is a persistent data representation describing the 3D modeled object representing the mechanical part. The B-rep may be the result of computations and/or a series of operations carried out during a designing phase of the 3D modeled object representing the mechanical part. The shape of the mechanical part displayed on the screen of the computer when the modeled object is represented is (e.g. a tessellation of) the B-rep. In examples, the B-rep represents a part of the model object.

A B-Rep includes topological entities and geometrical entities. Topological entities are: face, edge, and vertex. Geometrical entities are 3D objects: surface, plane, curve, line, point. By definition, a face is a bounded portion of a surface, named the supporting surface. An edge is a bounded portion of a curve, named the supporting curve. A vertex is a point in 3D space. They are related to each other as follows. The bounded portion of a curve is defined by two points (the vertices) lying on the curve. The bounded portion of a surface is defined by its boundary, this boundary being a set of edges lying on the surface. The boundary of the edges of the face are connected by sharing vertices. Faces are connected by sharing edges. Two faces are adjacent if they share an edge. Similarly, two edges are adjacent if they share a vertex. In the CAD system, the B-Rep gathers in an appropriate data structure the "is bounded by" relationship, the relationship between topological entities and supporting geometries, and mathematical descriptions of supporting geometries. An internal edge of a B-Rep is an edge shared by exactly two faces. By definition, a boundary edge is not shared, it bounds only one face. By definition, a boundary face is bounded by at least one boundary edge. A B-Rep is said to be closed if all its edges are internal edges. A B-Rep is said to be open is it includes at least one boundary edge. A closed B-Rep is used to model a thick 3D volume because it defines the inside portion of space (virtually) enclosing material. An open B-Rep is used to model a 3D skin, which represents a 3D object the thickness of which is sufficiently small to be ignored.

A key advantage of the B-Rep over any other representation types used in CAD modeling is its ability to represent arbitrary shapes exactly. All other representations in use, such as point clouds, distance fields and meshes, perform an approximation of the shape to represent by discretization. The B-Rep, on the other hand, contains surface equations that represent the exact design and therefore constitutes a true "master model" for further manufacturing, whether this be generation of toolpaths for CNC, or discretizing into the correct sample density for a given 3D Printer technology. In other words, by using a B-Rep, the 3D model may be an exact representation of the manufactured object. The B-Rep is also advantageous for simulating the behavior of a 3D model. In terms of stress, thermal, electromagnetic, or other analysis, it supports local refinement of the simulation meshes to capture physical phenomena, and for kinematics it supports true contact modeling between curved surfaces. Finally, a B-Rep allows a small memory and/or file footprint. First, because the representation contains surfaces based only on parameters. In other representations such as meshes, the equivalent surface comprises up to thousands of triangles. Second, because a B-Rep does not contain any history-based information.

The method may be included in a production process, which may comprise, after performing the method, producing a physical product corresponding to the modeled object designed/processed/outputted by the method. The production process may comprise the following steps:

- (e.g. automatically) applying the method, thereby obtaining the CAD model comprising one or more draft surfaces;
- using the obtained CAD model for manufacturing the part/product.

Using a CAD model for manufacturing designates any real-world action or series of action that is/are involved in/participate to the manufacturing of the product/part represented by the CAD model. Using the CAD model for manufacturing may for example comprise the following steps:

- editing the obtained CAD model;
- performing simulation(s) based on the CAD model or on a corresponding CAE model (e.g. the CAE model from which the CAD model stems, after a CAE to CAD conversion process), such as simulations for validation of mechanical, use and/or manufacturing properties and/or constraints (e.g. structural simulations, thermodynamics simulation, aerodynamic simulations);
- editing the CAD model based on the results of the simulation(s);
- optionally (i.e. depending on the manufacturing process used, the production of the mechanical product may or may not comprise this step), (e.g. automatically) determining a manufacturing file/CAM file based on the (e.g. edited) CAD model, for production/manufacturing of the manufacturing product;
- sending the CAD file and/or the manufacturing file/CAM file to a factory; and/or
- (e.g. automatically) producing/manufacturing, based on the determined manufacturing file/CAM file or on the CAD model, the mechanical product originally represented by the model outputted by the method. This may include feeding (e.g. automatically) the manufacturing file/CAM file and/or the CAD file to the machine(s) performing the manufacturing process.

This last step of production/manufacturing may be referred to as the manufacturing step or production step. This step manufactures/fabricates the part/product based on the CAD model and/or the CAM file, e.g. upon the CAD model and/or CAD file being fed to one or more manufacturing machine(s) or computer system(s) controlling the machine(s). The manufacturing step may comprise performing any known manufacturing process or series of manufacturing processes, for example one or more additive manufacturing steps, one or more cutting steps (e.g. laser cutting or plasma cutting steps), one or more stamping steps, one or more forging steps, one or more bending steps, one or more deep drawing steps, one or more molding steps, one or more machining steps (e.g. milling steps) and/or one or more punching steps. Because the design method improves the design of a model (CAE or CAD) representing the part/product, the manufacturing and its productivity are also improved.

Editing the CAD model may comprise, by a user (i.e. a designer), performing one or more editions of the CAD model, e.g. by using a CAD solution. The modifications of the CAD model may include one or more modifications each of a geometry and/or of a parameter of the CAD model. The modifications may include any modification or series of modifications performed on a feature tree of the model (e.g. modification of feature parameters and/or specifications) and/or modifications performed on a displayed representation of the CAD model (e.g. a B-rep). The modifications are modifications which maintain the technical functionalities of the part/product, i.e. the user performs modifications which may affect the geometry and/or parameters of the model but only with the purpose of making the CAD model technically more compliant with the downstream use and/or manufacturing of the part/product. Such modifications may include any modification or series of modification that make the CAD model technically compliant with specifications of the machine(s) used in the downstream manufacturing process. Such modifications may additionally or alternatively include any modification or series of modification that make the CAD model technically compliant with a further use of the product/part once manufactured, such modification or series of modifications being for example based on results of the simulation(s).

The CAM file may comprise a manufacturing step up model obtained from the CAD model. The manufacturing step up may comprise all data required for manufacturing the mechanical product so that it has a geometry and/or a distribution of material that corresponds to what is captured by the CAD model, possibly up to manufacturing tolerance errors. Determining the production file may comprise applying any CAM (Computer-Aided Manufacturing) or CAD-to-CAM solution for (e.g. automatically) determining a production file from the CAD model (e.g. any automated CAD-to-CAM conversion algorithm). Such CAM or CAD-to-CAM solutions may include one or more of the following software solutions, which enable automatic generation of manufacturing instructions and tool paths for a given manufacturing process based on a CAD model of the product to manufacture:

- Fusion 360,
- FreeCAD,
- CATIA,
- SOLIDWORKS,
- The NC Shop Floor programmer of Dassault Systèmes illustrated on https://my.3dexperience.3ds.com/welcome/fr/compass-world/rootroles/nc-shop-floor-programmer,
- The NC Mill-Turn Machine Programmer of Dassault Systèmes illustrated on https://my.3dexperience.3ds.com/welcome/fr/compass-world/rootroles/nc-mill-turn-machine-programmer, and/or
- The Powder Bed Machine Programmer of Dassault Systèmes illustrated on https://my.3dexperience.3ds.com/welcome/fr/compass-world/rootroles/powder-bed-machine-programmer.

The product/part may be a molded part, i.e. a part manufactured by molding (e.g. injection-molding). In such a case, the production process may comprise the step of determining the CAM file. This step may be carried out automatically, by any suitable CAM solution to automatically obtain a CAM file from a CAD model of a molded part. The determining of the CAM file may comprise (e.g. automatically) performing a sequence of molding checks based on the CAD model to check that the geometry and/or distribution of material captured by the CAD model is adapted for molding, and (e.g. automatically) performing the appropriate corrections if the CAD model is not adapted for molding. Performing the checks and the appropriate corrections (if any) may be carried out automatically, or, alternatively, by a user (e.g. a molding engineer), for example using a CAD and/or CAM solution that allows a user to perform the appropriate corrections on the CAD model but constraints him/her corrections that make the CAD model compliant with specifications of the molding tool(s). The checks may include: verifying that the virtual product as represented by the CAD model is consistent with the dimensions of the mold and/or verifying that the CAD model comprises all the draft angles required for demolding the product, as known per se from molding. The determining of the CAM file may then further comprise determining, based on the CAD model, a quantity of liquid material to be used for molding, and/or a time to let the liquid material harden/set inside the mold, and outputting a CAM file comprising these parameters. The production process then comprises (e.g. automatically) performing the molding based on the outputted file, where the mold shapes, for the determined hardening time, a liquid material into a shape that corresponds to the geometry and/or distribution of material captured by the CAD model, e.g. up to a tolerance error (e.g. up to the incorporation of draft angles or to the modification of draft angles, for demolding).

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g., one for the program, and possibly one for the database).

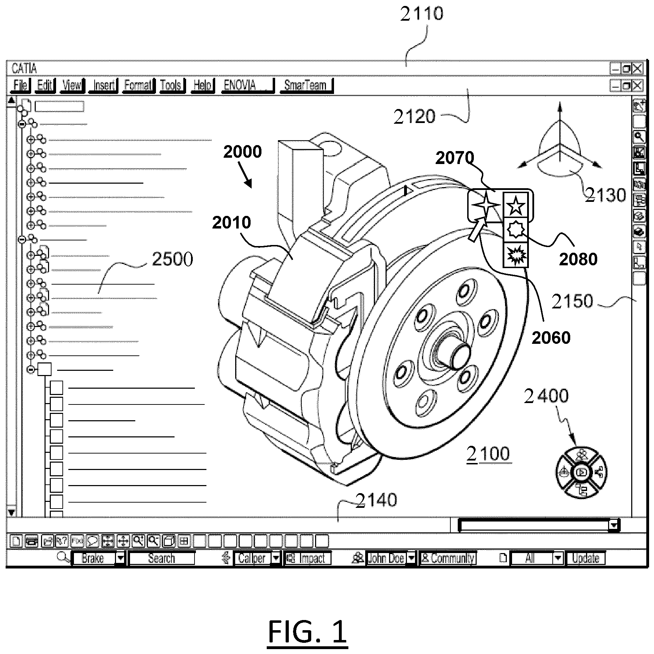

FIG. 1 shows an example of the GUI of the system, wherein the system is a CAD system.

The GUI 2100 may be a typical CAD-like interface, having standard menu bars 2110, 2120, as well as bottom and side toolbars 2140, 2150. Such menu- and toolbars contain a set of user-selectable icons, each icon being associated with one or more operations or functions, as known in the art. Some of these icons are associated with software tools, adapted for editing and/or working on the 3D modeled object 2000 displayed in the GUI 2100. The software tools may be grouped into workbenches. Each workbench comprises a subset of software tools. In particular, one of the workbenches is an edition workbench, suitable for editing geometrical features of the modeled product 2000. In operation, a designer may for example pre-select a part of the object 2000 and then initiate an operation (e.g. change the dimension, color, etc.) or edit geometrical constraints by selecting an appropriate icon. For example, typical CAD operations are the modeling of the punching, or the folding of the 3D modeled object displayed on the screen. The GUI may for example display data 2500 related to the displayed product 2000. In the example of the figure, the data 2500, displayed as a "feature tree", and their 3D representation 2000 pertain to a brake assembly including brake caliper and disc. The GUI may further show various types of graphic tools 2130, 2070, 2080 for example for facilitating 3D orientation of the object, for triggering a simulation of an operation of an edited product or render various attributes of the displayed product 2000. A cursor 2060 may be controlled by a haptic device to allow the user to interact with the graphic tools.

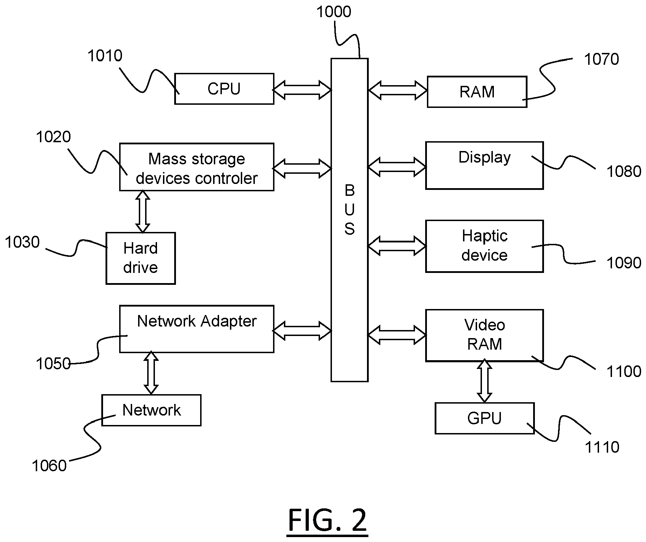

FIG. 2 shows an example of the system, wherein the system is a client computer system, e.g. a workstation of a user.

The client computer of the example comprises a central processing unit (CPU) 1010 connected to an internal communication BUS 1000, a random-access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard, or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

An implementation of the CAD volume draft operator is now discussed.

The implementation is related to the field of geometry processing, 3D CAD analysis, modeling and editing, 3D reconstruction and recognition, simulation, and design of experiment.

More specifically, the implementation finds, from a 3D surface mesh or point cloud approximating a closed surface, some volume CAD features that build the 3D model resulting in this surface. Yet more specifically, the implementation detects draft features that have been used. The implementation provides a technique that works for arbitrary profiles.

The implementation employs segmentation techniques to divide the 3D data into subparts, and to proceed to a detection of which of those subparts may be part of a draft. The implementation then gathers the subparts that seem to be the result of the same feature using a condition. The implementation then detects which kind of volume feature to be set, addition or removal of material, with the help of an orientation-coherent parameterization of the profile.

Such an implementation demands a little amount of computations by an efficient implementation of the transition from local computations to global ones. The number of computations of the efficient implementation is minimal by using a maximum of geometric information available in the data to make the right choices. Said implementation is very generic and is able to work with all kinds of draft is not limited to canonics, like cones or planes.

A draft operator on a 3D CAD model consists in the bending of one or more faces on a part relatively to a neutral face. This feature is used to ease the extraction of an object from a mold. Apply a draft operator needs the definition of a draft angle $\theta$ and a neutral face.

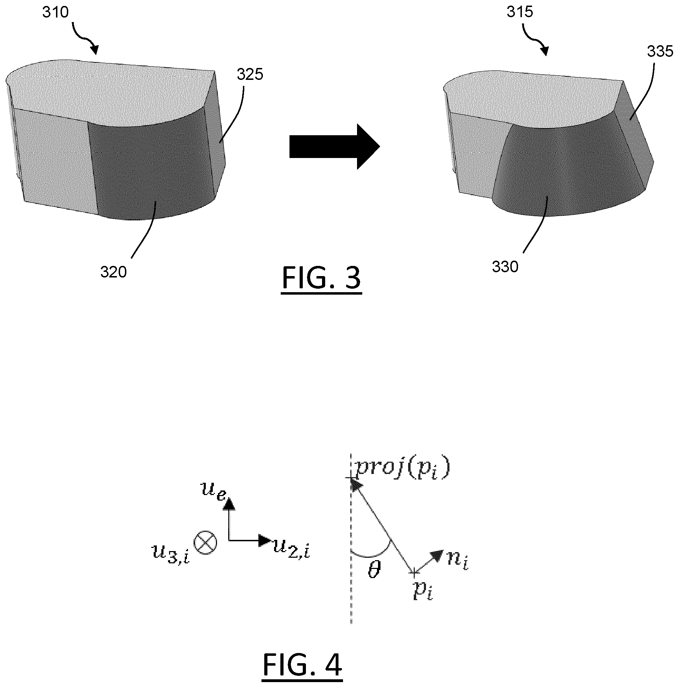

FIG. 3 presents an example of a draft feature where the draft process is applied to faces 320 and 325 of the extrusion 310 to obtain the model 315. The resulted drafted faces of face 320 and face 325 are faces 330 and 335, respectively.

An example of detection of draft parts according to the implementation is now discussed:

**Elementary draft parts detection:**

A surface $S \subset \mathbb{R}^3$ is a perfect draft surface if and only if it satisfies the following condition:

$$\exists u \in \mathbb{R}^3 \setminus \{(0,0,0)\}, \theta \in \mathbb{R}^3 : \quad \forall p \in S, \quad n_p \cdot u = sin\theta. \qquad (1)$$

The notation $\bar{n}$ is defined as the mean normal of $S$:

$$\bar{n} = \frac{1}{|S|} \int_S n \, dvol_S.$$

Thus, if $S$ is a perfect draft surface, then $\bar{n} \cdot u = sin\theta$. Therefore, in equivalence to Eq. (1), a surface $S \subset \mathbb{R}^3$ is a perfect draft surface if and only if it satisfies the following condition:

$$\exists u \in \mathbb{R}^3 \setminus \{(0,0,0)\} : \quad \forall p \in S, \quad (n_p - \bar{n}) \cdot u = 0. \qquad (2)$$

The condition expressed in Eq. (2) may be relaxed to define what may be an approximate draft surface.

Let $\mathcal{J}_S : \mathbb{R}^3 \longrightarrow \mathbb{R}_+$ be defined by:

$$\mathcal{J}_S(u) = \frac{1}{\mathcal{A}_S} \int_S \left( u \cdot (n_p - \bar{n}) \right)^2 dvol_S$$

where

$$\mathcal{A}_S = \int_S dvol_S$$

and $vol_S$ is the canonical measure on $S$, in other words, the measure induced by the Lebesgue measure on $\mathbb{R}^3$.

The relaxation of Eq. (2) then can be represented as:

$$\exists u \in \mathbb{R}^3 : |u| = 1 \text{ and } \mathcal{J}_S(u) \leq \epsilon, \qquad (3)$$

for some $\epsilon > 0$ , for instance $\epsilon = 10^{-3}$). The Eq. (3) is equivalent to:

$$\min \{\mathcal{J}_S(u) \mid u \in \mathbb{R}^3, \ |u| = 1\} \leq \epsilon. \qquad (4)$$

By noticing that $\mathcal{J}_S(u) = u^T \widetilde{\mathbf{T}}_S u$ with:

$$\widetilde{\mathbf{T}}_S = \frac{1}{\mathcal{A}_S} \int_S (n - \bar{n})(n - \bar{n})^T dvol_S$$

one can see that in order to decide if a surface $S$ can be an approximate draft, one has to solve the optimization problem:

$$\min_{u \in \mathbb{R}^3} \quad u^T \widetilde{\mathbf{T}}_S u$$
$$s.t. \ |u| = 1$$

which is equivalent to find the smallest eigenvalue $\lambda_S^m$ of $\tilde{T}_S$ as well as its associated eigenvector $u_S^m$. Here,

$\lambda_S^m = \mathcal{J}_S(u_S^m)$ is the minimum value of the problem.

The condition to be an approximate surface of draft (of axis $u_S^m$ ) is then:

$$\lambda_S^m \leq \epsilon \qquad\qquad (COND)$$

The implementation now can use (COND) as an approximated representations on a surface, like a mesh or a point cloud. The implementation is able to be applied on a point cloud as soon as the normal vectors corresponding to the points are also provided to the method.

For example, for a triangle mesh $\mathcal{M}(\mathcal{V}, \mathcal{E}, \mathcal{F})$, corresponds to a piecewise linear surface $S$, thereby it holds exactly that:

$$\overline{n_S} = \frac{1}{\sum_{\tau \in \mathcal{F}} \mathcal{A}_\tau} \sum_{\tau \in \mathcal{F}} \mathcal{A}_\tau n_\tau$$

$$\widetilde{\mathbf{T}}_S = \frac{1}{\sum_{\tau \in \mathcal{F}} \mathcal{A}_\tau} \sum_{\tau \in \mathcal{F}} \mathcal{A}_\tau (n_\tau - \overline{n_S})(n_\tau - \overline{n_S})^T$$

where $\mathcal{F}$ is the set of triangle faces of the mesh, $|\tau|$ is the area of triangle $\tau \in \mathcal{F}$ and $n_\tau$ is the normal vector of triangle $\tau \in \mathcal{F}$.

The implementation then chooses the drafting axis $u_e$ such that $\bar{n} \cdot u_e = \sin\theta > 0$:

$$\begin{cases} u_e = u_{\mathcal{M}}^m \ if \ \bar{n} \cdot u_{\mathcal{M}}^m > 0 \\ u_e = -u_{\mathcal{M}}^m \ else \end{cases}$$

and the draft angle $\theta$ can be computed as:

$$\theta = arcsin(\bar{n} \cdot u_e).$$

The implementation is now discussed when being applied on a whole surface representing a complex 3D shape.

Let $S$ be a surface embedded in $\mathbb{R}^3$. The implementation first proceeds to a segmentation of that surface, using for instance the method of European Patent Application EP23306186.0, filed on 11 July 2023 by Dassault Systèmes, which is incorporated herein by reference. As a result of the segmentation, the implementation gets a partition of the surface into elementary disjoint sub-surfaces ( $S_1^{el}, \cdots, S_N^{el}$ ).

The implementation then set a sufficiently small constant tolerance $\epsilon > 0$, for example the value of the tolerance may be $5 \times 10^{-3}$. Then, for every $i \in [\![1, N]\!]$, the implementation applies the following process:

- Computing the centered normal matrix $\widetilde{\mathbf{T}}_{S_i^{el}}$ of $S_i^{el}$ : for instance if $S(\mathcal{V}, \mathcal{E}, \mathcal{T})$ is a triangle mesh, and $S_i^{el}(\mathcal{V}_i^{el}, \mathcal{E}_i^{el}, \mathcal{T}_i^{el})$ is a sub-mesh, then the implementation uses the discrete formula:

$$\overline{n_{S_i^{el}}} = \frac{1}{\mathcal{A}_{S_i^{el}}} \sum_{\tau \in \mathcal{T}_i^{el}} \mathcal{A}_\tau n_\tau$$

$$\widetilde{\mathbf{T}}_{S_i^{el}} = \frac{1}{\mathcal{A}_{S_i^{el}}} \sum_{\tau \in \mathcal{T}_i^{el}} \mathcal{A}_\tau \left(n_\tau - \overline{n_{S_i^{el}}}\right) \left(n_\tau - \overline{n_{S_i^{el}}}\right)^T$$

- Computing the eigenvalue $\lambda_{S_i^{el}}^1 < \lambda_{S_i^{el}}^2 < \lambda_{S_i^{el}}^3$ of $\widetilde{\mathbf{T}}_{S_i^{el}}$.

- If $\lambda_{S_i^{el}}^1 \leq \epsilon$, then the implementation labels $S_i^{el}$ as a potential (elementary) draft part, and stores the computed $\lambda_{S_i^{el}}^1$, the centered normal matrix $\widetilde{\mathbf{T}}_{S_i^{el}}$, as well as the mean normal $\overline{n_{S_i^{el}}}$.

- If $\lambda_{S_i^{el}}^2 \leq \epsilon$ and $\lambda_{S_i^{el}}^3 \leq \epsilon$, the implementation labels $S_i^{el}$ as a potential plane part.

An example of aggregation of draft surface according to the implementation is now discussed:

**Draft surface aggregation:**

To aggregate elementary drafts, the implementation uses a similar technique as the one described in European Patent Application EP21306184.9, filed on 31 August 2021 by Dassault Systèmes, which is incorporated by reference, with a different aggregation of the centered normal matrixes.

For $S_1$ and $S_2$ two disjoint sub-parts of $S$ that have been detected as potential drafts, the implementation computes the mean normal and the centered normal matrix of their union using the following formulas:

$$\overline{n_{S_1 \sqcup S_2}} = \frac{\mathcal{A}_{S_1}}{\mathcal{A}_{S_1} + \mathcal{A}_{S_2}} \overline{n_{S_1}} + \frac{\mathcal{A}_{S_2}}{\mathcal{A}_{S_1} + \mathcal{A}_{S_2}} \overline{n_{S_2}}$$

$$\widetilde{\mathbf{T}}_{S_1 \sqcup S_2} = \frac{\mathcal{A}_{S_1}}{\mathcal{A}_{S_1} + \mathcal{A}_{S_2}} \widetilde{\mathbf{T}}_{S_1} + \frac{\mathcal{A}_{S_2}}{\mathcal{A}_{S_1} + \mathcal{A}_{S_2}} \widetilde{\mathbf{T}}_{S_2} + \frac{\mathcal{A}_{S_1}}{\mathcal{A}_{S_1} + \mathcal{A}_{S_2}} \frac{\mathcal{A}_{S_2}}{\mathcal{A}_{S_1} + \mathcal{A}_{S_2}} \left(\overline{n_{S_1}} - \overline{n_{S_2}}\right)\left(\overline{n_{S_1}} - \overline{n_{S_2}}\right)^T$$

This allows to avoid making the computation of these elements on all the elements of the resulting surface (e.g. on all the faces for a mesh).

The implementation then computes the associated smallest eigenvalue $\tilde{\lambda}_{S_1 \sqcup S_2}^m$ of $\widetilde{\mathbf{T}}_{S_1 \cup S_2}$. The implementation then compares the draft energy of the gathered parts, i.e., $\mathcal{J}_{S_1 \sqcup S_2}\left(\mathrm{u}_{S_1 \sqcup S_2}^m\right) = \tilde{\lambda}_{S_1 \sqcup S_2}^m$ to the weighted sum of the draft energies of the segmented parts. The draft energy of a surface $S'$ is the nonnegative value $\min_{|u|=1} \mathcal{J}_{S'}(u) = \tilde{\lambda}_{S'}^m$).

Introduce the quantity:

$$\tilde{\delta}(S_1, S_2) = \tilde{\lambda}_{S_1 \sqcup S_2} - \frac{\mathcal{A}_{S_1}}{\mathcal{A}_{S_1} + \mathcal{A}_{S_2}} \tilde{\lambda}_{S_1} - \frac{\mathcal{A}_{S_2}}{\mathcal{A}_{S_1} + \mathcal{A}_{S_2}} \tilde{\lambda}_{S_2}$$

The quantity $\tilde{\delta}(S_1, S_2)$ is always nonnegative, but the closer it gets to 0, the less the energy of $(S_1, S_2)$ increases when being gathered as a single draft part. This means that the implementation intends more to gather them as a single draft.

The implementation may use the following criterion for deciding whether or nor $S_1$ and $S_2$ should be gathered:

$$\tilde{\delta}(S_1, S_2) \leq \eta$$

with $\eta$ sufficiently small, e.g., $10^{-3}$.

In some variations, the implementation compares $\tilde{\lambda}^m_{S_1 \sqcup S_2}$ to $\epsilon$ to see if $S_1 \cup S_2$ is a potential draft part in the same sense that for the elementary draft parts.

The example aggregation discussed is particularly well-suited for drafts that have similar draft angles. However, the implementation may be applied to aggregate drafts with extrusions/undrafted extrusions (that can be seen as drafts with a draft angle of value 0) in order to build the extrusion before applying the draft only on some sub-parts of the extrusion.

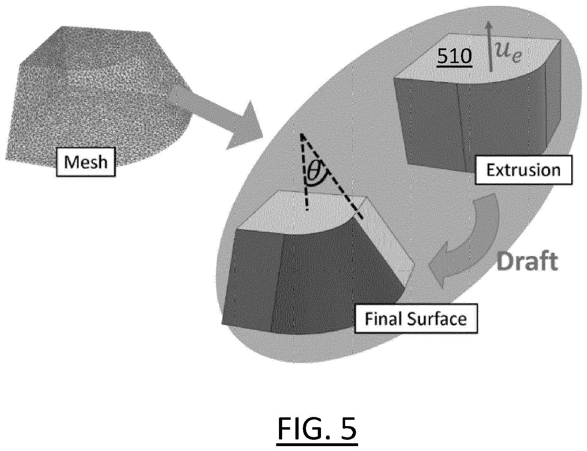

FIG. 5 shows an example surface for which the aggregation is applied. Indeed, the two hidden planes in the back that are orthogonal to the top plane 510 one are not drafted but they should be used to compute the profile curve of the extrusion made before the draft.

In such examples, for $S_1$ a draft and $S_2$ an (undrafted) extrusion, the mean normal and the centered normal matrix of their union are computed using the following formulas:

$$\overline{n_{S_1 \sqcup S_2}} = \overline{n_{S_1}}$$

$$\widetilde{\mathbf{T}}_{S_1 \sqcup S_2} = \frac{\mathcal{A}_{S_1}}{\mathcal{A}_{S_1} + \mathcal{A}_{S_2}} \widetilde{\mathbf{T}}_{S_1} + \frac{\mathcal{A}_{S_2}}{\mathcal{A}_{S_1} + \mathcal{A}_{S_2}} \mathbf{T}_{S_2}$$

with $\boldsymbol{T}_{S_2}$ the uncentered normal matrix of $S_2$ defined in the background art ($\boldsymbol{T}_{S_2} = \frac{1}{|S_2|} \int_{S_2} nn^T \, dvol_{S_2}$).

Then, the quantity $\tilde{\delta}(S_1, S_2)$ is:

$$\tilde{\delta}(S_1, S_2) = \tilde{\lambda}_{S_1 \sqcup S_2} - \frac{\mathcal{A}_{S_1}}{\mathcal{A}_{S_1} + \mathcal{A}_{S_2}} \tilde{\lambda}_{S_1} - \frac{\mathcal{A}_{S_2}}{\mathcal{A}_{S_1} + \mathcal{A}_{S_2}} \lambda_{S_2}$$

with $\lambda_{S_2}$ the smallest eigenvalue of $\boldsymbol{T}_{S_2}$

For such a case, the implementation keeps the information of which sub-part should be drafted.

Finally, to aggregate two surfaces $S_1$ and $S_2$ both composed of drafted and undrafted extrusions, the implementation splits the surfaces into drafted and undrafted extrusion surfaces. The implementation then aggregates the mean normal and centered normal matrixes of the draft surfaces using the first formulas and then aggregates the centered normal matrixes of the undrafted extrusions surfaces using the aggregation from the already cited European Patent Application EP21306184.9. Finally, the implementation combines the obtained centered normal matrixes using the formula to combine drafted and undrafted centered normal matrixes.

An example of adding of closing planes according to the implementation is now discussed:

**Adding Closing Planes:**

If $S_1$ is labeled as a potential draft part and $S_2$ is labelled as a potential plane part, the implementation decides whether or not to merge them or following a similar principle as in the already cited European Patent Application EP21306184.9.

The implementation builds the matrix:

$$\widetilde{\mathbf{T}}_{S_1 \perp S_2} = \frac{\mathcal{A}_{S_1}}{\mathcal{A}_{S_1} + \mathcal{A}_{S_2}} \widetilde{\mathbf{T}}_{S_1} + \frac{\mathcal{A}_{S_2}}{\mathcal{A}_{S_1} + \mathcal{A}_{S_2}} \left( \mathbf{I} - \mathbf{T}_{S_2} \right)$$

and computes the smallest eigenvalue $\lambda^1_{S_1 \perp S_2}$ of the matrix $\widetilde{\mathbf{T}}_{S_1 \perp S_2}$.

Then, the implementation based on the following quantity:

$$\delta_\perp(S_1, S_2) = \lambda_{S_1 \perp S_2} - \frac{\mathcal{A}_{S_1}}{\mathcal{A}_{S_1} + \mathcal{A}_{S_2}} \lambda_{S_1} - \frac{\mathcal{A}_{S_2}}{\mathcal{A}_{S_1} + \mathcal{A}_{S_2}} \lambda_{S_2}$$

decides to label $S_2$ as a potential closing plane of $S_1$ if $\delta_\perp(S_1, S_2) \le \mu$ when $\mu$ is sufficiently small, e.g., $10^{-3}$.

An example of building an elementary profile curve according to the implementation is now discussed:

**Elementary Profile Curve Building:**

The implementation uses a parameterization method and a curve fitting method as in in European Patent Application EP21305671.6, filed on 21 May 2021 by Dassault Systèmes, which is incorporated by reference, in order to get approximated profile curves for the elementary drafted (and undrafted) extrusions parts that are parameterized in a way that is coherent with the orientation of the surface.

For undrafted extrusion parts, the elementary profiles are computed like in the already cited European Patent Application EP21306184.9. On the other hand, and for draft parts, the implementation uses the already cited European Patent Application EP21305671.6 to compute the parameterization, and to define the profile plane in the following way:

Let $h_0 = \max_{p \in \mathcal{S}}(u_e \cdot p)$ and $p_{max} = argmax_{p \in \mathcal{S}}(u_e \cdot p)$

The implementation defines the profile plane as the plane containing $p_{max}$ and orthogonal to $u_e$ (e.g., the plane 510 in FIG. 5).

To project a point $p_i$ from the drafted surface to the profile plane, the implementation performs as the following:

- Let $u_{3,i} = \frac{u_e \times n_i}{|u_e \times n_i|}$ and $u_{2,i} = u_{3,i} \times u_e = (u_e \times n_i) \times u_e$

- Then $proj(p_i) = p_i + (h_0 - u_e \cdot p_i)u_e - tan\theta(h_0 - u_e \cdot p_i)\frac{u_{2,i}}{|u_{2,i}|}$

- Consider the projection $\mathbf{P} = \left(u^2_{S_i^{el}}, u^3_{S_i^{el}}\right)^T$ which projects points to the plane orthogonal to $u_e$.

when $u^2_{S_i^{el}}$ and $u^3_{S_i^{el}}$ are the eigenvectors of the centered normal matrix associated to the higher eigenvalues.

Furthermore, $\mathcal{P} = \mathbf{P}\text{proj}(\mathcal{S})$ is the set of points from which the implementation can compute the sketch/profile of the draft where

$$\mathbf{P}\,\text{proj}(p) = \mathbf{P}(p_i - tan\theta(h_0 - u_e \cdot p_i)\frac{u_{2,i}}{|u_{2,i}|}).$$

FIG. 4 presents a schematic example of the projection.

Then, for $p \in \mathcal{S}$, the parameterization $u(p)$ is defined using the vector field $X(p) = \frac{1}{\left(\frac{(h_0 - h(p))tan\theta}{r_0(u(p))} + 1\right)} e_{u(p)}$ with:

- $h_0$ the height of the profile support plane
- $r_0(u(p))$ the curvature radius at the height of the profile support plane
  - $r_0(u(p))$ is such that $(h_0 - h(p))tan\theta + r_0(u(p)) = \frac{1}{\kappa_{max}(p)}$ with $\kappa_{max}(p)$ the maximal curvature value at $p$
- $e_{u(p)}$ the unitary vector aligned with the profile: $e_{u(p)} = \frac{u_e \times n(p)}{|u_e \times n(p)|}$
- $h(p)$ the height of $p$ with respect to the drafting axis $u_e$ : $h(p) = u_e \cdot p$

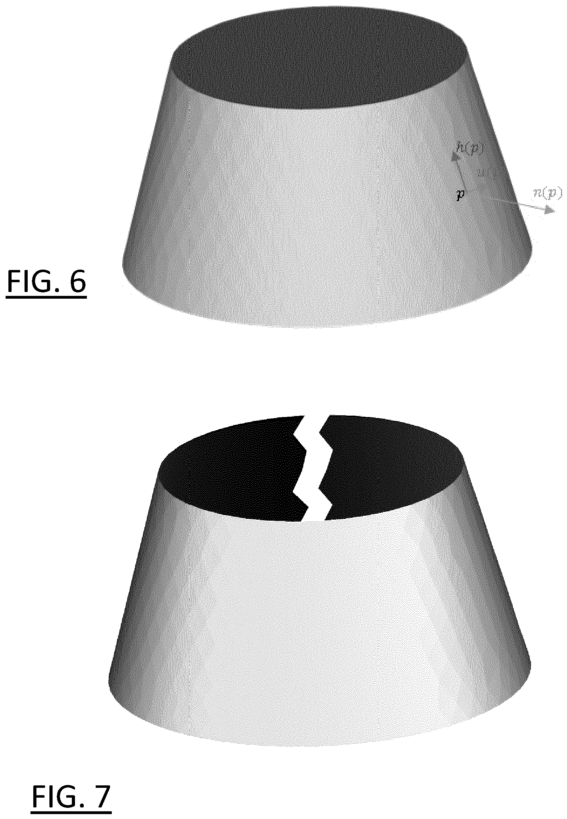

Fig. 6 illustrates the representation of a parameterization as discussed above. Fig. 7 illustrates the result obtained by a parameterization. Here the greyscale color gradient shows the evolution of u(p), thus parts that have the same colors have the same parameter u(p) and parts whose colors are close have close values for this parameter.

An example of profile aggregation according to the implementation is now discussed:

**Profile aggregation:**

The implementation then aggregates the elementary profile curves to compute the complete profiles. In some cases, even if the aggregation of adjacent drafted surfaces is valid, the obtained profile curves may cross each other or not connect. Therefore, some known techniques such as the technique used in the already cited European Patent Application EP21306184.9 cannot be used.

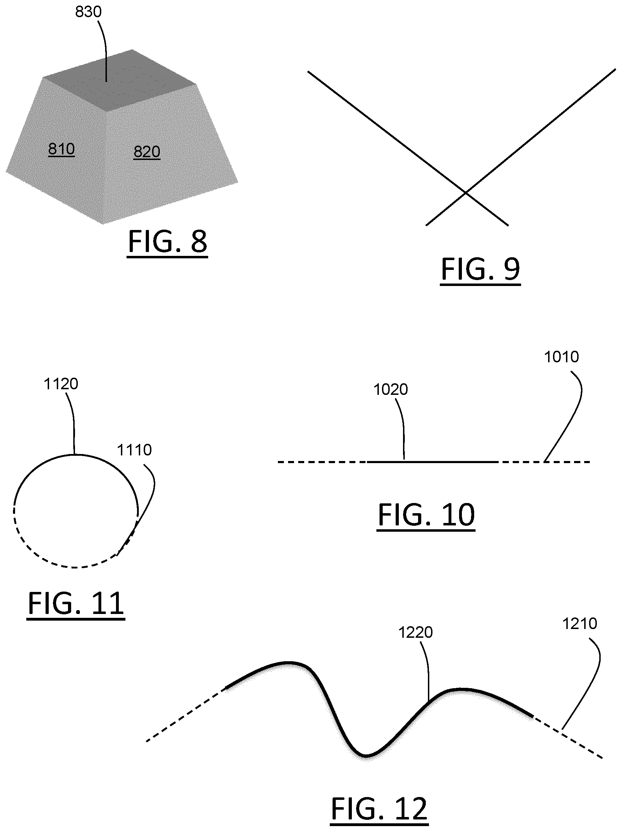

FIG. 8 presents an example of such a case. In this example, plane 810 and plane 820 are drafted while plane 830 corresponds to the profile plane. Before the draft, the connection between those planes is not continuous. Thus, the projected curves would be according to FIG. 9 which clearly intersect.

In order to combine such profiles, the implementation splits or extends the curves where they are intersecting before aggregating the curves. Thus, during aggregation, the implementation considers extended elementary curves like, for instance:

- the infinite line for a segment, for example the line 1010 for the segment 1020 in FIG. 10;
- the full circle for an arc, for example the circle 1110 for the arc 1120 in FIG. 11; and
- the spline extended with extreme tangents for a spline, for example the extended spline 1220 for the spline 1220 in FIG. 12.

For combination of elementary curves, the implementation considers the resulting curve extended with its extreme tangents, similar to the spline case depicted in FIG. 12.

Furthermore, the implementation may only build drafts with closed profile curve.

If an extrusion part $S'$ with drafted surfaces is an aggregation of several elementary drafted and undrafted extrusion parts ($S_{i_1}^{el}, \cdots, S_{i_m}^{el}$), with respective profile curves ($\gamma_{i_1}, ..., \gamma_{i_m}$) in the profile plane of $S'$, the implementation builds aggregated profiles for instance using the following algorithm :

For a chosen starting $k \in [\![1, m]\!]$

$$\gamma \leftarrow \gamma_{i_k}, Elt \leftarrow \{k\}, S_{tot} = S_{i_k}^{el}$$

- While $\gamma$ is not closed:

  ∘ Pick $l \in [\![1, m]\!] \backslash Elt$ such that $S_{i_l}^{el}$ is adjacent to $S_{tot}$
  ∘ If no such $l$ exist

     - Keep $\gamma$ only if it is closed (or if it can be closed, e.g., with the method described in European Patent Application EP22305354.7, filed on 22 March 2022 by Dassault Systèmes, which is incorporated by reference)
     - Break

  ∘ Extend or cut the extremities of $\gamma$ and $\gamma_{i_l}$ to get $\gamma'$ and $\gamma_{i_l}'$

     $$\gamma \leftarrow C(\gamma', \gamma_{i_l}'), El \leftarrow El \cup \{l\}$$

Here $C(\gamma_1, \gamma_2)$ is defined as in the already cited European Patent Application EP21306184.9. This algorithm can run for every $\in [\![1, m]\!]$ to build $m$ aggregated curves.

An example of pad/pocket classification according to the implementation is now discussed:

**Pad/Pocket classification:**

Finally, to decide if the retrieved extrusion (before applying the draft) is a pad or a pocket, the implementation uses exactly the procedure as in the already cited European Patent Application EP21306184.9.

**Claims**

1. A computer-implemented method for CAD volume draft operator detection in a discrete 3D model representing a mechanical part, the method comprising:

   - obtaining a segmentation of the discrete 3D model, the discrete 3D model including a skin representing an outer surface of the mechanical part, the segmentation comprising segments each representing a skin portion;
   - iteratively grouping segments, where two segments of a pair of segments are grouped if:

     ◦ each segment of the pair is a drafted surface and both segments have a same respective drafting axis, and:

       ▪ both segments have a same respective draft angle relative to the respective drafting axis, or
       ▪ at least one segment has a zero angle relative to the respective drafting axis; or

     ◦ one segment of the pair is a drafted surface and the other segment is a closing plane;

   at least one iteration grouping a pair of segments with at least one segment having a non-zero draft angle relative to the respective drafting axis;
   - determining one or more CAD volume draft operators, each CAD volume draft operator corresponding to a respective group.

2. The method of claim 1, wherein the method comprises determining all segments that are drafted surfaces, including performing a test of whether

$$\exists u \in \mathbb{R}^3 \setminus \{(0,0,0)\}, \theta \in \mathbb{R}^3 : \quad \forall p \in S, \quad n_p \cdot u = \boldsymbol{sin(\theta)},$$

where $S$ is a segment and $n_p$ is the normal vector to the segment $S$ at point $p$, the surfaces satisfying the test being determined as drafted surfaces.

3. The method of claim 2, wherein the performing of the test comprises evaluating, for each segment $S$:

$$\exists u \in \mathbb{R}^3 : |u| = 1 \text{ and } \mathcal{J}_S(u) \leq \epsilon$$

where $\mathcal{J}_S : \mathbb{R}^3 \longrightarrow \mathbb{R}_+$ and is defined by:

$$\mathcal{J}_S(u) = \frac{1}{\mathcal{A}_S} \int_S \left( u \cdot (n_p - \bar{n}) \right)^2 dvol_S,$$

$\mathcal{A}_S = \int_S dvol_S$ and $vol_s$ is the canonical measure on $S$, $\epsilon > 0$, $\bar{n}$ is the mean normal of $S$ defined as $\bar{n} = \frac{1}{|S|} \int_S n dvol_s$.

4. The method of claim 3, wherein the evaluation comprises solving an optimization problem of the type:

$$\min_{u\in\mathbb{R}^3} \quad u^T\widetilde{\mathbf{T}}_S u$$
$$s.t. \quad |u| = 1$$

where $\tilde{\mathbf{T}}_S$ is of the type:

$$\widetilde{\mathbf{T}}_S = \frac{1}{\mathcal{A}_S}\int_S (n - \bar{n})(n - \bar{n})^T dvol_S.$$

**5.** The method of claim 4, wherein the solving of the optimization problem comprises finding the smallest eigenvalue ($\lambda_S^m$ ) of $\tilde{\mathbf{T}}_S$ as well as its associated eigenvector $u_S^m$ , wherein the testing comprises testing

$$\lambda_S^m \le \epsilon$$

wherein $\lambda_S^m$ the smallest eigenvalue.

**6.** The method of any of claims 1 to 5, wherein iteratively grouping segments comprises one or more iterations of:

- exploring a pair of segments;
- determining whether:

  ◦ a first disparity between the value of a draft-detection objective function for a union of the segments of the explored pair and a weighted sum of the values of the draft-detection objective function for the segments of the explored pair is lower than a first predefined threshold ($\epsilon$), the sum being weighted based on the areas of the segments, or
  ◦ a second disparity ($\delta_\perp(S_1,S_2)$) between the value of a draft-closing objective function for the segments of the explored pair and the weighted sum is lower than a second predefined threshold, the draft-closing objective function rewarding orthogonality of an input segment with respect to a drafting axis of another input segment;

- grouping the segments of the explored pair if the first disparity is lower than the first predefined threshold or if the second disparity is lower than the second predefined threshold.

**7.** The method of claim 6, wherein

- the value of the draft-detection objective function for an input segment is a smallest eigenvalue of a normal matrix of the input segment; and/or
- the value of the draft-closing objective function is a smallest eigenvalue of a matrix that is a weighted sum of a normal matrix of the other input segment and the identity minus a normal matrix of the input segment, the sum being weighted based on the areas of the input segments.

**8.** The method of claim 7, wherein:

- the first disparity is of the type:

$$\delta(S_1, S_2) = \lambda_{S_1\sqcup S_2}^m - \frac{\mathcal{A}_{S_1}}{\mathcal{A}_{S_1}+\mathcal{A}_{S_2}}\lambda_{S_1}^m - \frac{\mathcal{A}_{S_2}}{\mathcal{A}_{S_1}+\mathcal{A}_{S_2}}\lambda_{S_2}^m,$$

where $S_1$ and $S_2$ are the two segments of the explored pair, $\lambda_{S_1\sqcup S_2}^m$ is the smallest eigenvalue of the normal matrix $\tilde{\mathbf{T}}_{S_1\cup S_2}$ of the union of $S_1$ and $S_2$, $\lambda_{S_1}^m$ is the smallest eigenvalue of the normal matrix $\tilde{\mathbf{T}}_{S1}$ of $S_1$, $\lambda_{S_2}^m$ is the smallest eigenvalue of the normal matrix $\tilde{\mathbf{T}}_{S2}$ of $S_2$ if $S_2$ has a non-zero draft angle and the smallest eigenvalue of the normal matrix $\mathbf{T}_{S_2}$ of $S_2$ if $S_2$ has a zero draft angle, where

$$\widetilde{\mathbf{T}}_{S_1 \sqcup S_2} = \frac{\mathcal{A}_{S_1}}{\mathcal{A}_{S_1} + \mathcal{A}_{S_2}}\widetilde{\mathbf{T}}_{S_1} + \frac{\mathcal{A}_{S_2}}{\mathcal{A}_{S_1} + \mathcal{A}_{S_2}}\widetilde{\mathbf{T}}_{S_2}$$
$$+ \frac{\mathcal{A}_{S_1}}{\mathcal{A}_{S_1} + \mathcal{A}_{S_2}}\frac{\mathcal{A}_{S_2}}{\mathcal{A}_{S_1} + \mathcal{A}_{S_2}}\left(\overline{n_{S_1}} - \overline{n_{S_2}}\right)\left(\overline{n_{S_1}} - \overline{n_{S_2}}\right)^{T}$$

when $S_1$ and $S_2$ having non-zero draft angles,

$$\mathcal{A}_{S_1}$$

being the area of $S_1$,

$$\mathcal{A}_{S_2}$$

being the area of $S_2$, and

$$\widetilde{\mathbf{T}}_{S_1 \sqcup S_2} = \frac{\mathcal{A}_{S_1}}{\mathcal{A}_{S_1} + \mathcal{A}_{S_2}}\widetilde{\mathbf{T}}_{S_1} + \frac{\mathcal{A}_{S_2}}{\mathcal{A}_{S_1} + \mathcal{A}_{S_2}}\mathbf{T}_{S_2}$$

when $S_1$ has a non-zero draft angle and $S_2$ has a zero draft angle,

$$\mathcal{A}_{S_1}$$

being the area of $S_1$,

$$\mathcal{A}_{S_2}$$

being the area of $S_2$; and/or
- the second disparity is of the type:

$$\delta_\perp(S_1, S_2) = \lambda^m_{S_1 \perp S_2} - \frac{\mathcal{A}_{S_1}}{\mathcal{A}_{S_1} + \mathcal{A}_{S_2}}\lambda^m_{S_1} - \frac{\mathcal{A}_{S_2}}{\mathcal{A}_{S_1} + \mathcal{A}_{S_2}}\lambda^m_{S_2},$$

where $\lambda^m_{S_1 \perp S_2}$ is the smallest eigenvalue of the matrix

$$\mathbf{T}_{S_1 \perp S_2} = \frac{\mathcal{A}_{S_1}}{\mathcal{A}_{S_1} + \mathcal{A}_{S_2}}\widetilde{\mathbf{T}}_{S_1} + \frac{\mathcal{A}_{S_2}}{\mathcal{A}_{S_1} + \mathcal{A}_{S_2}}\left(\mathbf{I} - \mathbf{T}_{S_2}\right)$$

where $S_1$ is the other input segment and $S_2$ is the input segment, $\lambda^m_{S_1}$ is the smallest eigenvalue of the normal matrix $\widetilde{\mathbf{T}}_{S_1}$ of $S_1$, and $\lambda^m_{S_2}$ is the smallest eigenvalue of the normal matrix $\mathbf{T}_{S_2}$ of $S_2$; with $T_{S_2}$ being an uncentered normal matrix of $S_2$ defined as

$$T_{S_2} = \frac{1}{|S_2|} \int_{S_2} nn^T dvol_{S_2}$$

where denotes a normal vector and $|S_2|$ is a surface area of $S_2$ .

9. The method of any one of claims 1 to 8, wherein for each respective group, determining the CAD volume draft operator corresponding to the respective group includes building a profile curve of the respective group.

10. The method of claim 9, wherein building the profile curve comprises:

   - for each segment of the respective group, providing a respective profile curve of the segment; and
   - iteratively concatenating the respective profile curves, where a pair of respective profile curves are concatenated if a third disparity between the respective profile curves of the pair is smaller than a third predefined threshold.

11. The method of any one of claims 9 to 10, wherein for each respective group, determining the CAD volume draft operator corresponding to the respective group further includes determining a draft type of the CAD volume draft operator based on the built profile curve.

12. The method of claim 11, wherein determining the draft type comprises:

   - determining whether the profile curve is closed or not; and
   - computing a total curvature of the profile curve,

   where:

   - the CAD volume draft operator is a draft surface if the profile curve is open and the absolute value of the total curvature is strictly smaller than $2\pi$,the CAD volume draft operator is a pad operator if the profile curve is closed and the total curvature equals $\beta 2\pi$, and
   - the CAD volume draft operator is a pocket operator if the profile curve is closed and the total curvature equals $-\beta 2\pi$,

   where $\beta \in \{-1, 1\}$; wherein optionally the total curvature is of the type:

$$\kappa_{tot} = \int_I \kappa_\gamma(t)dt$$

   where $\kappa_\gamma(t)$ is the algebraic curvature of the curve $\gamma$ at parameter *t*.

13. A computer program comprising instructions for performing the method of any one of claims 1 to 12.

14. A computer-readable data storage medium having recorded thereon the computer program of claim 13.

15. A computer system comprising a processor coupled to a memory, the memory having recorded thereon the computer program of claim 13.

FIG. 1

1000

1010  CPU

1020  Mass storage
devices controler

1030  Hard
drive

1050  Network Adapter

1060  Network

B
U
S

1070  RAM

1080  Display

1090  Haptic
device

1100  Video
RAM

1110  GPU

## FIG. 2

EP 4 492 274 A1

## FIG. 3

## FIG. 4

## FIG. 5

FIG. 6

FIG. 7

830

810    820

## FIG. 8

## FIG. 9

1120

1110

## FIG. 11

1010

1020

## FIG. 10

1220    1210

## FIG. 12

Europäisches
Patentamt

European
Patent Office

Office européen
des brevets

# EUROPEAN SEARCH REPORT

**Application Number**

**EP 23 30 6189**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 141 725 A1 (DASSAULT SYSTEMES [FR]) 1 March 2023 (2023-03-01) * abstract * * claims 1-15 * * paragraph [0011] * * paragraph [0014] * * paragraph [0020] * * paragraph [0031] - paragraph [0033] * ----- | 1-15 | INV. G06F30/12 G06T17/10 G06V20/64 |
| X | US 2008/049046 A1 (BAE SEOCK HOON [KR] ET AL) 28 February 2008 (2008-02-28) * paragraph [0088] * ----- | 1-15 | |
| A | MARCO ATTENE ET AL: "Hierarchical Structure Recovery of Point-Sampled Surfaces", COMPUTER GRAPHICS FORUM : JOURNAL OF THE EUROPEAN ASSOCIATION FOR COMPUTER GRAPHICS, WILEY-BLACKWELL, OXFORD, vol. 29, no. 6, 12 April 2010 (2010-04-12) , pages 1905-1920, XP071488170, ISSN: 0167-7055, DOI: 10.1111/J.1467-8659.2010.01658.X * Section 4.3 * ----- | 1-15 | TECHNICAL FIELDS SEARCHED (IPC) G06F G06T G06V |

The present search report has been drawn up for all claims

| Place of search | Date of completion of the search | Examiner |
|---|---|---|
| Munich | 19 December 2023 | Sohrt, Wolfgang |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 30 6189

This annex lists the patent family members relating to the patent documents cited in  the above-mentioned European search report.
The members are as contained in the European Patent Office EDP file on
The European Patent Office is in no way liable for these particulars which are merely given for the purpose of information.

19-12-2023

| Patent document cited in search report | | Publication date | Patent family member(s) | | Publication date |
|---|---|---|---|---|---|
| EP 4141725 | A1 | 01-03-2023 | CN | 115730357 A | 03-03-2023 |
| | | | EP | 4141725 A1 | 01-03-2023 |
| | | | JP | 2023035946 A | 13-03-2023 |
| | | | US | 2023085000 A1 | 16-03-2023 |
| US 2008049046 | A1 | 28-02-2008 | CN | 101067872 A | 07-11-2007 |
| | | | DE | 102006058017 A1 | 08-11-2007 |
| | | | JP | 2007299373 A | 15-11-2007 |
| | | | KR | 100753536 B1 | 30-08-2007 |
| | | | US | RE49149 E | 26-07-2022 |
| | | | US | 2008049046 A1 | 28-02-2008 |

EPO FORM P0459

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 21305195
- EP 21305293, Dassault
- EP 21305671
- EP 21306184, Dassault Systèmes
- EP 23306186
- EP 22305354